# EUROPEAN PATENT APPLICATION

(11) **EP 3 761 117 A1**
(43) Date of publication of application: **06.01.2021**
(21) Application number: 19777099.3
(22) Date of filing: 28.01.2019
(51) Int. Cl.: G03F 7/40, C25D 5/02, C25D 5/34, G03F 7/004, G03F 7/039, G03F 7/20, H05K 3/18

(54) **METHOD FOR MANUFACTURING PLATED MOLDED ARTICLE**

(30) Priority: 27.03.2018 JP 2018060344
(71) Applicant: TOKYO OHKA KOGYO CO., LTD., Kawasaki-shi, Kanagawa 211 0012 (JP)
(72) Inventor: MOMOZAWA, Aya, Kawasaki-shi, Kanagawa 211-0012 (JP); KUROIWA,Yasushi, Kawasaki-shi, Kanagawa 211-0012 (JP); KATAYAMA, Shota, Kawasaki-shi, Kanagawa 211-0012 (JP); YAMAMOTO, Yuta, Kawasaki-shi, Kanagawa 211-0012 (JP); EBISAWA, Kazuaki, Kawasaki-shi, Kanagawa 211-0012 (JP)
(74) Representative: Plasseraud IP
(86) International application number: PCT/JP2019/002818
(87) International publication number: WO 2019/187591

(57) **Abstract**

The present invention provides a method for manufacturing a plated molded article, the method being capable of forming the plated molded article having good adhesion with respect to a metal surface on a substrate using a mold, while forming a pattern used as the mold for forming the plated molded article by using a photosensitive composition while suppressing footing in the pattern. A resist pattern used as the mold for forming the plated molded article is formed by using the photosensitive composition that includes a sulfur-containing compound having a predetermined structure and/or a nitrogen-containing compound, and before forming the plated molded article, ashing is performed on the surface comprising a metal that is exposed from a non-resist section of the resist pattern used as the mold.

## Description

### TECHNICAL FIELD

The present invention relates to a method of manufacturing a plated article using a pattern formed with a photosensitive composition as a template.

### BACKGROUND ART

Photofabrication is now the mainstream of a microfabrication technique. Photofabrication is a generic term describing the technology used for manufacturing a wide variety of precision components such as semiconductor packages. The manufacturing is carried out by applying a photoresist composition to the surface of a processing target to form a photoresist layer, patterning this photoresist layer using photolithographic techniques, and then conducting chemical etching, electrolytic etching, or electroforming based mainly on electroplating, using the patterned photoresist layer (photoresist pattern) as a mask.

In recent years, high density packaging technologies have progressed in semiconductor packages along with downsizing electronics devices, and the increase in package density has been developed on the basis of mounting multi-pin thin film in packages, miniaturizing of package size, two-dimensional packaging technologies in flip-tip systems or three-dimensional packaging technologies. In these types of high density packaging techniques, connection terminals, for example, protruding electrodes (mounting terminals) known as bumps that protrude above the package or metal posts that extend from peripheral terminals on the wafer and connect rewiring with the mounting terminals, are disposed on the surface of the substrate with high precision.

In the photofabrication as described above, a photoresist composition is used, and chemically amplified photosensitive compositions containing an acid generator have been known as such a photoresist composition (see Patent Documents 1, 2 and the like). According to the chemically amplified photosensitive composition, an acid is generated from the acid generator upon irradiation with radiation (exposure) and diffusion of the acid is promoted through heat treatment, to cause an acid catalytic reaction with a base resin and the like in the composition resulting in a change to the alkali-solubility of the same.

Such chemically amplified positive-type photosensitive compositions are used, for example, in formation of plated articles such as bumps, metal posts, and Cu-rewiring by a plating step. Specifically, a photoresist layer having a desired film thickness is formed on a support such as a metal substrate using a chemically amplified photosensitive composition, and the photoresist layer is exposed through a predetermined mask pattern and is developed. Thereby, a photoresist pattern used as a template in which portions for forming plated articles have been selectively removed (stripped) is formed. Then, bumps or metal posts, and Cu rewiring can be formed by embedding a conductor such as copper into the removed portions (nonresist portions) using plating, and then removing the surrounding photoresist pattern.

In formation of connection terminals such as bumps and metal posts, or formation of Cu rewiring, by the plating method as mentioned above, a cross-sectional shape of a nonresist portion of a resist pattern serving as a template is desired to be rectangular. By doing so, a contact area between the connection terminals such as bumps, metal posts, and the like, or the bottom surface of the Cu rewiring and a support can be sufficiently secured. Thus, connection terminals or Cu rewiring with favorable adhesion to the support can be easily obtained.

However, when a resist pattern serving as a template for forming connection terminals such as bumps and metal posts or Cu rewiring is formed on a metal substrate using a chemically amplified positive-type photoresist composition as disclosed in Patent Documents 1 and 2, etc., "footing" in which the width of the bottom becomes narrower than that of the top in a nonresist portion due to protrusion of a resist portion toward the nonresist portion on the contacting surface between the substrate surface and the resist pattern tends to occur.

In order to solve such a problem related to the footing, a method is proposed using a chemically amplified positive-type photoresist composition containing a mercapto compound having a specific structure for forming a template for manufacturing plated articles, for example, connection terminals such as bumps and metal posts or Cu rewiring (see, Patent Document 3).

Patent Document 1: Japanese Unexamined Patent Application, Publication No. H9-176112
Patent Document 2: Japanese Unexamined Patent Application, Publication No. H11-52562
Patent Document 3: Japanese Unexamined Patent Application, Publication No. 2015-184389

### DISCLOSURE OF THE INVENTION

### Problems to be Solved by the Invention

However, as mentioned in Patent Document 3, when a template for forming plated articles, for example, connection terminals such as bumps and metal posts or Cu rewiring is formed using a resist composition to which a footing suppressing component such as a mercapto compound has been added and the template is used to form the plated articles on a metal substrate, there is concern that adhesiveness of the plated article to the metal substrate is damaged.

The present invention has been made in view of the above-mentioned problem. An object of the present invention is to provide a method of manufacturing a plated article, the method being capable of forming a plated article having favorable adhesiveness with respect to a metal surface on a substrate using a template for forming the plated article while suppressing footing in a pattern, which is for use as the template, upon formation of the pattern using a photosensitive composition.

### Means for Solving the Problems

After conducting extensive studies in order to achieve the above-mentioned object, the present inventors have found that the above-mentioned problem can be solved by forming a resist pattern to be used as a template for forming a plated article using a photosensitive composition which includes a sulfur-containing compound and/or a nitrogen-containing compound each having a predetermined structure and, before the plated article is formed therefrom, subjecting a surface made of metal exposed from a nonresist portion of the resist pattern to be used as the template to ashing, and the present inventors have completed the present invention. Specifically, the present invention provides the following.

The present invention provides a method of manufacturing a plated article, the method including: preparing a substrate having a metal layer on a surface thereof and a photosensitive composition;
applying the photosensitive composition onto the substrate to form a photosensitive composition film;
exposing the photosensitive composition film;
developing the exposed photosensitive composition film to form a pattern so that at least a portion of the metal layer on the substrate is exposed; and
forming a plated article using the pattern as a template, in which the photosensitive composition includes a sulfur-containing compound and/or a nitrogen-containing compound, in which the sulfur-containing compound includes a sulfur atom to be coordinated with metal constituting the metal layer, in which the nitrogen-containing compound includes a nitrogen atom constituting a nitrogen-containing aromatic heterocycle to be coordinated with metal constituting the metal layer, in which the method further includes subjecting the exposed surface of the metal layer to an ashing treatment between forming the pattern and forming the plated article.

The present invention also provides a method of providing a photosensitive composition, the method including providing the photosensitive composition to a process line carrying out the above-mentioned method of manufacturing a plated article.

### Effects of the Invention

The present invention can provide a method of manufacturing a plated article, the method being capable of forming a plated article having favorable adhesiveness with respect to a metal surface on a substrate using a template for forming the plated article while suppressing footing in a pattern, which is for use as the template, upon formation of the pattern using a photosensitive composition.

### BRIEF DESCRIPTION OF THE DRAWINGS

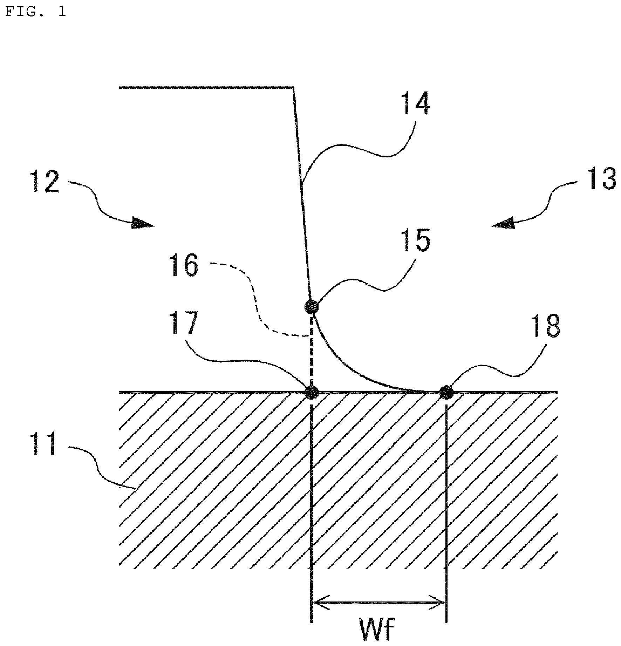

FIG. 1 is a diagram schematically illustrating a cross-section of a resist pattern observed when a footing amount in a nonresist portion of the resist pattern is measured in Examples and Comparative Examples.

### PREFERRED MODE FOR CARRYING OUT THE INVENTION

### <<Method of manufacturing plated article>>

A method of manufacturing a plated article includes preparing a substrate having a metal layer on a surface thereof and a photosensitive composition;
applying the photosensitive composition onto the substrate to form a photosensitive composition film;
exposing the photosensitive composition film;
developing the exposed photosensitive composition film to form a pattern so that at least a portion of the metal layer on the substrate is exposed; and
forming a plated article using the pattern as a template. The method of manufacturing further includes subjecting the exposed surface of the metal layer to an ashing treatment between forming the pattern and forming the plated article.

A step of preparing a substrate having a metal layer on a surface thereof and a photosensitive composition is hereinafter also referred to as a "preparation step". A step of applying the photosensitive composition to form a photosensitive composition film is also referred to as a "film formation step". A step of exposing the photosensitive composition film is also referred to as an "exposure step". A step of developing the exposed photosensitive composition film to form a pattern so that at least a portion of the metal layer on the substrate is exposed is also referred to as a "pattern formation step". A step of subjecting the exposed surface of the metal layer to the ashing treatment is also referred to as an "ashing step". A step of forming a plated article using the pattern as a template is also referred to as a "plating step".

The photosensitive composition used for forming the pattern serving as the template in the above-mentioned method of manufacturing a plated article is not particularly limited as long as the photosensitive composition includes a sulfur-containing compound and/or a nitrogen-containing compound each having a predetermined structure and from which a pattern having a desired film thickness can be formed. The sulfur-containing compound mentioned above includes a sulfur atom to be coordinated with metal constituting the metal layer on the substrate. The nitrogen-containing compound mentioned above includes a nitrogen atom constituting a nitrogen-containing aromatic heterocycle to be coordinated with the metal constituting the metal layer on the substrate. The photosensitive composition including such a sulfur-containing compound and/or a nitrogen-containing compound can be used to suppress footing in a pattern formed as a template for plating, and as a result, to form a pattern for the template of which a non-patterned portion has a favorable rectangular cross-sectional shape.

On the other hand, when the pattern formed with the photosensitive composition including the sulfur-containing compound and/or the nitrogen-containing compound is used as a template to manufacture a plated article, a plated article having favorable adhesiveness with respect to a surface of the metal layer on the substrate may be difficult to form. However, when the exposed surface of the metal layer is subjected to the ashing treatment between the pattern formation step and the plating step, the plated article having favorable adhesiveness with respect to the surface of the metal layer on the substrate can be formed even if the pattern formed with the photosensitive composition including the sulfur-containing compound and/or the nitrogen-containing compound is used as the template.

Each of the steps included in the method of manufacturing a plated article will now be sequentially described.

### <Preparation step>

In the preparation step, a substrate having a metal layer on a surface thereof and a photosensitive composition are prepared. The substrate having a metal layer on a surface thereof is not particularly limited, and conventionally known substrates can be used. Examples thereof include a substrate for an electronic component and a substrate on which a predetermined wiring pattern is formed. For the substrate, a substrate having a metal layer is used. As metal species constituting the metal layer, copper, gold and aluminum are preferred, and copper is more preferred. The photosensitive composition is not particularly limited as long as the photosensitive composition includes the sulfur-containing compound and/or the nitrogen-containing compound each having a predetermined structure and from which a pattern having a desired film thickness can be formed. The photosensitive composition will be described in detail after the method of manufacturing a plated article is described.

### <Film formation step>

In the film formation step, the photosensitive composition is applied onto the substrate to form a photosensitive composition film. The photosensitive composition film is formed on the substrate, for example, as follows. In other words, a liquid photosensitive composition is applied onto the substrate and heated to remove a solvent and thus to form the photosensitive composition film having a desired film thickness. The thickness of the photosensitive composition film is not particularly limited as long as it is possible to form a resist pattern which has the desired film thickness serving as a template. The thickness of the photosensitive composition film is not particularly limited, and is preferably 0.5 µm or more, more preferably 0.5 µm or more and 300 µm or less, particularly preferably 1 µm or more and 150 µm or less, and most preferably 3 µm or more and 100 µm or less.

As a method of applying a photosensitive composition onto a substrate, methods such as the spin coating method, the slit coat method, the roll coat method, the screen printing method and the applicator method can be employed. Pre-baking is preferably performed on a photosensitive layer. The conditions of pre-baking may differ depending on the components in a photosensitive composition, the blending ratio, the thickness of a coating film and the like. They are usually about 2 minutes or more and 120 minutes or less at 70°C or more and 200°C or less, and preferably 80°C or more and 150°C or less.

### <Exposure step>

In the exposure step, the photosensitive composition film formed on the substrate is exposed. The exposed photosensitive composition is patterned by development in the below-mentioned pattern formation step. Therefore, the photosensitive composition film is exposed in a position-selective manner so that an area for forming the plated article is removed by development. Specifically, the photosensitive composition film is irradiated (exposed) in a position-selective manner with an actinic ray or radiation, for example, an ultraviolet radiation or visible light with a wavelength of 300 nm or more and 500 nm or less through a mask having a predetermined pattern.

Low pressure mercury lamps, high pressure mercury lamps, super high pressure mercury lamps, metal halide lamps, argon gas lasers, etc. can be used for the light source of the radiation. The radiation may include micro waves, infrared rays, visible lights, ultraviolet rays, X-rays, γ-rays, electron beams, proton beams, neutron beams, ion beams, etc. The irradiation dose of the radiation may vary depending on the constituent of the photosensitive composition, the film thickness of the photosensitive layer, and the like. For example, when an ultra-high-pressure mercury lamp is used, the dose may be 100 mJ/cm² or more and 10,000 mJ/cm² or less.

When the photosensitive composition includes a photoacid generator, diffusion of an acid can be promoted by heating the photosensitive composition film using a known method after the exposure to change the alkali solubility of the photosensitive composition film at an exposed portion in the photosensitive composition film.

### <Pattern formation step>

In the pattern formation step, the exposed photosensitive composition film is developed to form a pattern so that at least a portion of the metal layer on the substrate is exposed. The exposed photosensitive composition film is developed in accordance with a conventionally known method, and an unnecessary portion is dissolved and removed to form a template for forming a plated article. At this time, as a developing solution, an alkaline aqueous solution is preferably used.

As the developing solution, an aqueous solution of an alkali such as, for example, sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5.4.0]-7-undecene or 1,5-diazabicyclo[4.3.0]-5-nonane can be used. Also, an aqueous solution prepared by adding an adequate amount of a watersoluble organic solvent such as methanol or ethanol, or a surfactant to the above aqueous solution of the alkali can be used as the developing solution.

The developing time may vary depending on the composition of the photosensitive composition, the film thickness of the photosensitive composition film, and the like. Usually, the developing time is 1 minute or more and 30 minutes or less. The method of the development may be any one of a liquid-filling method, a dipping method, a paddle method, a spray developing method, and the like.

After the development, the exposed photosensitive composition film is washed with running water for 30 seconds or more and 90 seconds or less, and then dried with an air gun, an oven, or the like. In this manner, it is possible to manufacture a substrate with a template, the substrate having a resist pattern serving as a template for forming a plated article on the metal layer thereof.

### <Ashing step>

In the ashing step, the exposed surface of the metal layer in a non-patterned portion of the resist pattern serving as the template for forming a plated article is subjected to the ashing treatment. A footing suppressing effect upon formation of the template for forming a plated article is believed to be obtained from coordination of the sulfur-containing compound and/or the nitrogen-containing compound with a surface of the metal layer on the substrate. However, as mentioned above, when the pattern formed with the photosensitive composition including the sulfur-containing compound and/or the nitrogen-containing compound is used as the template to form a plated article, there is a problem in which adhesiveness of the plated article with respect to the surface of the metal layer may be easily damaged.

In response, the present inventors have examined and found that the ashing treatment can be performed to form a plated article having favorable adhesiveness with respect to the surface of the metal layer even if the pattern formed with the photosensitive composition including the sulfur-containing compound and/or the nitrogen-containing compound is used as the template. For this reason, it is presumed that the sulfur-containing compound and/or the nitrogen-containing compound derived from the photosensitive composition and to be coordinated with the surface of the metal layer prevents the plated article from adhering to the substrate.

The ashing treatment is not particularly limited as long as the ashing treatment does not damage the resist pattern serving as the template for forming a plated article to such an extent that a plated article having a desired shape cannot be formed. Preferable ashing treatment methods include a method using an oxygen plasma. For ashing with respect to the surface of the metal layer on the substrate using the oxygen plasma, the oxygen plasma may be generated using a known oxygen plasma generator, and the surface of the metal layer on the substrate may be irradiated with the oxygen plasma.

Various gases which have conventionally been used for plasma treatment together with oxygen can be mixed with a gas to be used for generating the oxygen plasma within a range where the object of the present invention is not impaired. Examples of such gases include a nitrogen gas, a hydrogen gas, a CF₄ gas, and the like. Ashing conditions using the oxygen plasma are not particularly limited to within a range where the object of the present invention is not impaired, but treatment time is, for example, in a range of 10 seconds or more and 20 minutes or less, preferably in a range of 20 seconds or more and 18 minutes or less, and more preferably in a range of 30 seconds or more and 15 minutes or less. By setting the treatment time by the oxygen plasma to the above range, an effect of improving the adhesiveness of the plated article can be easily achieved without changing a shape of the resist pattern.

### <Plating step>

A conductor such as a metal may be embedded, by plating, into a nonresist portion in the resist pattern serving as the template formed by the above-mentioned method on the substrate to form a plated article, for example, like a contacting terminal such as a bump and a metal post, or Cu rewiring. Note here that there is no particular limitation on the plating method, and various conventionally known methods can be employed. As a plating liquid, in particular, a solder plating liquid, a copper plating liquid, a gold plating liquid, and a nickel plating liquid are suitably used. The remaining template is finally removed with a stripping liquid or the like in accordance with a conventional method.

According to the above-mentioned method, a plated article having favorable adhesiveness with respect to a metal surface on a substrate using a template for forming the plated article can be formed while suppressing footing in a pattern, which is for use as the template, upon formation of the pattern using a photosensitive composition.

### <<Photosensitive composition>>

The photosensitive composition is not particularly limited as long as the photosensitive composition includes a sulfur-containing compound and/or a nitrogen-containing compound each having a predetermined structure mentioned below and from which a pattern having a desired film thickness can be formed. For the photosensitive composition, various conventionally known negative-type photosensitive compositions and positive-type photosensitive compositions can be used.

Examples of the positive-type photosensitive composition include a nonchemically amplified positive-type photosensitive composition containing a quinone diazide group-containing compound and an alkali soluble resin; a chemically amplified positive-type photosensitive composition containing a photoacid generator and a resin having an acid dissociable leaving group which leaves under an action of an acid generated from the photoacid generator by exposure to increase its solubility in alkali, and the like. Examples of the negative-type photosensitive composition include a polymerizable negative-type photosensitive composition containing an alkali soluble resin, a photopolymerizable monomer, and a photoinitiator; a chemically amplified negative-type photosensitive composition containing an alkali soluble resin, a cross-linking agent, and an acid generator; a chemically amplified negative-type photosensitive composition for a solvent development process, the photosensitive composition containing at least a photoacid generator and a resin having an acid dissociable leaving group which leaves under an action of an acid generated from the photoacid generator by exposure to increase its polarity, and the like.

As the photosensitive composition, the positive-type photosensitive composition is preferably used from the viewpoint of easily detaching the resist pattern used as the template after plating and molding. Furthermore, the chemically amplified positive-type photosensitive composition is preferable as the positive-type photosensitive composition from the viewpoints of excellent resolution and easy formation of fine pattern.

For the chemically amplified positive-type photosensitive composition suitable among the photosensitive compositions, a particularly preferable aspect will now be described in detail.

Note here that the sulfur-containing compound and/or the nitrogen-containing compound will be described in detail as a component of the chemically amplified positive-type photosensitive composition. The below-mentioned sulfur-containing compound and/or nitrogen-containing compound is, of course, applicable to various photosensitive compositions other than chemically amplified positive-type photosensitive compositions being preferable. An amount of the sulfur-containing compound and/or the nitrogen-containing compound in the photosensitive composition is preferably 0.01 parts by mass or more and 5 parts by mass or less, more preferably 0.02 parts by mass or more and 3 parts by mass or less, and particularly preferably 0.05 parts by mass or more and 2 parts by mass or less when the solid component of the photosensitive composition is determined as 100 parts by mass.

### <Chemically amplified positive-type photosensitive composition>

The chemically amplified positive-type photosensitive composition is preferably a composition containing an acid generator (A) which generates acid upon exposure to an irradiated active ray or radiation (hereinafter, also referred to as the "acid generator (A)"), a resin (B) whose solubility in alkali increases under an action of acid (hereinafter, also referred to as the "resin (B)"), and a sulfur-containing compound and/or a nitrogen-containing compound (C) each having a predetermined structure. Such a preferable chemically amplified positive-type photosensitive composition may include components such as an alkali soluble resin (D), an acid diffusion suppressing agent (E), an organic solvent, and the like, as needed.

A film thickness of the resist pattern formed with the chemically amplified positive-type photosensitive composition is not particularly limited. The chemically amplified positive-type photosensitive composition is preferably used for forming a thick resist pattern.

As to the preferable chemically amplified positive-type photosensitive composition, essential or optional components thereof and a method of manufacturing the preferable chemically amplified positive-type photosensitive composition will now be described.

### [Acid generator (A)]

The acid generator (A) is a compound capable of producing an acid when irradiated with an active ray or radiation, and is not particularly limited as long as it is a compound which directly or indirectly produces an acid under the action of light. The acid generator (A) is preferably any one of the acid generators of the first to fifth aspects that will be described below. Hereinafter, suitable aspects of acid generators (A) used in the suitable chemically amplified positive-type photosensitive composition will be described as the first to fifth aspects.

The first aspect of the acid generator (A) may be a compound represented by the following formula (a1).

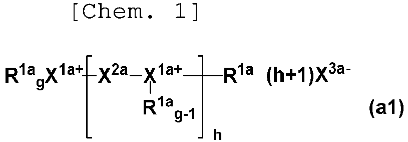

In the formula (a1), X^{1a} represents a sulfur atom or iodine atom respectively having a valence of g; g represents 1 or 2. h represents the number of repeating units in the structure within parentheses. R^{1a} represents an organic group that is bonded to X^{1a}, and represents an aryl group having 6 or more and 30 or less carbon atoms, a heterocyclic group having 4 or more and 30 or less carbon atoms, an alkyl group having 1 or more and 30 or less carbon atoms, an alkenyl group having 2 or more and 30 or less carbon atoms, or an alkynyl group having 2 or more and 30 or less carbon atoms, and R^{1a} may be substituted with at least one selected from the group consisting of an alkyl group, a hydroxyl group, an alkoxy group, an alkylcarbonyl group, an arylcarbonyl group, an alkoxycarbonyl group, an aryloxycarbonyl group, an arylthiocarbonyl group, an acyloxy group, an arylthio group, an alkylthio group, an aryl group, a heterocyclic group, an aryloxy group, an alkylsulfinyl group, an arylsulfinyl group, an alkylsulfonyl group, an arylsulfonyl group, an alkyleneoxy group, an amino group, a cyano group, a nitro group, and halogen atoms. The number of R^{1a}s is g + h(g - 1) + 1, and the R^{1a}s may be respectively identical to or different from each other. Furthermore, two or more R^{1a}s may be bonded to each other directly or via -O-, -S-, -SO-, -SO₂-, -NH-, -NR^{2a}-, -CO-, - COO-, -CONH-, an alkylene group having 1 or more and 3 or less carbon atoms, or a phenylene group, and may form a ring structure including X^{1a}. R^{2a} represents an alkyl group having 1 or more and 5 or less carbon atoms, or an aryl group having 6 or more and 10 or less carbon atoms.

X^{2a} represents a structure represented by the following formula (a2).

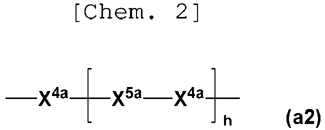

In the above formula (a2), X^{4a} represents an alkylene group having 1 or more and 8 or less carbon atoms, an arylene group having 6 or more and 20 or less carbon atoms, or a divalent group of a heterocyclic compound having 8 or more and 20 or less carbon atoms, and X^{4a} may be substituted with at least one selected from the group consisting of an alkyl group having 1 or more and 8 or less carbon atoms, an alkoxy group having 1 or more and 8 or less carbon atoms, an aryl group having 6 or more and 10 or less carbon atoms, a hydroxyl group, a cyano group, a nitro group, and halogen atoms. X^{5a} represents -O-, - S-, -SO-, -SO₂-, -NH-, -NR^{2a}-, -CO-, -COO-, -CONH-, an alkylene group having 1 or more and 3 or less carbon atoms, or a phenylene group.
h represents the number of repeating units of the structure in parentheses. X^{4a}s in the number of h + 1 and X^{5a}s in the number of h may be identical to or different from each other. R^{2a} has the same definition as described above.

X^{3a-} represents a counterion of an onium, and examples thereof include a fluorinated alkylfluorophosphoric acid anion represented by the following formula (a17) or a borate anion represented by the following formula (a18).

[Chem. 3] [(R^{3a})ⱼPF₆₋ⱼ]⁻ (a17)

In the formula (a17), R^{3a} represents an alkyl group having 80% or more of the hydrogen atoms substituted with fluorine atoms. j represents the number of R^{3a}s and is an integer of 1 or more and 5 or less. R^{3a}s in the number of j may be respectively identical to or different from each other.

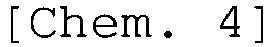

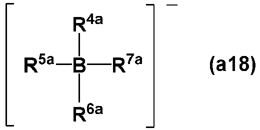

In the formula (a18), R^{4a} to R^{7a} each independently represents a fluorine atom or a phenyl group, and a part or all of the hydrogen atoms of the phenyl group may be substituted with at least one selected from the group consisting of a fluorine atom and a trifluoromethyl group.

Examples of the onium ion in the compound represented by the above formula (a1) include triphenylsulfonium, tri-p-tolylsulfonium, 4-(phenylthio)phenyldiphenylsulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl}sulfide, 4-(4-benzoyl-2-chlorophenylthio)phenylbis(4-fluorophenyl)sulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(diphenyl)sulfonio]thioxanthone, 4-[4-(4-tert-butylbenzoyl)phenylthio]phenyldi-p-tolylsulfonium, 4-(4-benzoylphenylthio)phenyldiphenylsulfonium, diphenylphenacylsulfonium, 4-hydroxyphenylmethylbenzylsulfonium, 2-naphthylmethyl(1-ethoxycarbonyl)ethylsulfonium, 4-hydroxyphenylmethylphenacylsulfonium, phenyl[4-(4-biphenylthio)phenyl]-4-biphenylsulfonium, phenyl[4-(4-biphenylthio)phenyl]-3-biphenylsulfonium, [4-(4-acetophenylthio)phenyl]diphenylsulfonium, octadecylmethylphenacylsulfonium, diphenyliodonium, di-p-tolyliodonium, bis(4-dodecylphenyl)iodonium, bis(4-methoxyphenyl)iodonium, (4-octyloxyphenyl)phenyliodonium, bis(4-decyloxy)phenyliodonium, 4-(2-hydroxytetradecyloxy)phenylphenyliodonium, 4-isopropylphenyl(p-tolyl)iodonium, 4-isobutylphenyl(p-tolyl)iodonium, or the like.

Among the onium ions in the compound represented by the above formula (a1), a preferred onium ion may be a sulfonium ion represented by the following formula (a19).

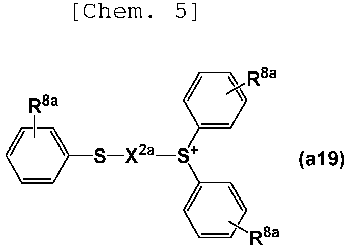

In the above formula (a19), R^{8a}s each independently represents a hydrogen atom or a group selected from the group consisting of alkyl, hydroxyl, alkoxy, alkylcarbonyl, alkylcarbonyloxy, alkyloxycarbonyl, a halogen atom, an aryl, which may be substituted, and arylcarbonyl. X^{2a} has the same definition as X^{2a} in the above formula (a1).

Specific examples of the sulfonium ion represented by the above formula (a19) include 4-(phenylthio)phenyldiphenylsulfonium, 4-(4-benzoyl-2-chlorophenylthio)phenylbis(4-fluorophenyl)sulfonium, 4-(4-benzoylphenylthio)phenyldiphenylsulfonium, phenyl[4-(4-biphenylthio)phenyl]-4-biphenylsulfonium, phenyl[4-(4-biphenylthio)phenyl]-3-biphenylsulfonium, [4-(4-acetophenylthio)phenyl]diphenylsulfonium, and diphenyl[4-(p-terphenylthio)phenyl]diphenylsulfonium.

In regard to the fluorinated alkylfluorophosphoric acid anion represented by the above formula (a17), R^{3a} represents an alkyl group substituted with a fluorine atom, and a preferred number of carbon atoms is 1 or more and 8 or less, while a more preferred number of carbon atoms is 1 or more and 4 or less. Specific examples of the alkyl group include linear alkyl groups such as methyl, ethyl, propyl, butyl, pentyl and octyl; branched alkyl groups such as isopropyl, isobutyl, sec-butyl and tert-butyl; and cycloalkyl groups such as cyclopropyl, cyclobutyl, cyclopentyl, and cyclohexyl. The proportion of hydrogen atoms substituted with fluorine atoms in the alkyl groups is usually 80% or more, preferably 90% or more, and even more preferably 100%. If the substitution ratio of fluorine atoms is less than 80%, the acid strength of the onium fluorinated alkylfluorophosphate represented by the above formula (a1) decreases.

A particularly preferred example of R^{3a} is a linear or branched perfluoroalkyl group having 1 or more and 4 or less carbon atoms and a substitution ratio of fluorine atoms of 100%. Specific examples thereof include CF₃, CF₃CF₂, (CF₃)₂CF, CF₃CF₂CF₂, CF₃CF₂CF₂CF₂, (CF₃)₂CFCF₂, CF₃CF₂(CF₃)CF, and (CF₃)₃C. j which is the number of R^{3a}s represents an integer of 1 or more and 5 or less, and is preferably 2 or more and 4 or less, and particularly preferably 2 or 3.

Preferred specific examples of the fluorinated alkylfluorophosphoric acid anion include [(CF₃CF₂)₂PF₄]⁻, [(CF₃CF₂)₃PF₃]⁻, [((CF₃)₂CF)₂PF₄]⁻, [((CF₃)₂CF)₃PF₃]⁻, [(CF₃CF₂CF₂)₂PF₄]⁻, [(CF₃CF₂CF₂)₃PF₃]⁻, [((CF₃)₂CFCF₂)₂PF₄]⁻, [((CF₃)₂CFCF₂)₃PF₃]⁻, [(CF₃CF₂CF₂CF₂)₂PF₄]⁻, or [(CF₃CF₂CF₂)₃PF₃]⁻. Among these, [(CF₃CF₂)₃PF₃]⁻, [(CF₃CF₂CF₂)₃PF₃]⁻, [((CF₃)₂CF)₃PF₃]⁻, [((CF₃)₂CF)₂PF₄]⁻, [((CF₃)₂CFCF₂)₃PF₃]⁻, or [((CF₃)₂CFCF₂)₂PF₄]⁻ are particularly preferred.

Preferred specific examples of the borate anion represented by the above formula (a18) include tetrakis(pentafluorophenyl)borate ([B(C₆F₅)₄]⁻), tetrakis[(trifluoromethyl)phenyl]borate([B(C₆H₄CF₃)₄]⁻), difluorobis(pentafluorophenyl)borate([(C₆F₅)₂BF₂]⁻), trifluoro(pentafluorophenyl)borate ([(C₆F₅)BF₃]⁻), and tetrakis(difluorophenyl)borate ([B(C₆H₃F₂)₄]-). Among these, tetrakis(pentafluorophenyl)borate ([B(C₆F₅)₄]⁻) is particularly preferred.

The second aspect of the acid generator (A) include halogen-containing triazine compounds such as 2,4-bis(trichloromethyl)-6-piperonyl-1,3,5-triazine, 2,4-bis(trichloromethyl)-6-[2-(2-furyl)ethenyl]-s-triazine, 2,4-bis(trichloromethyl)-6-[2-(5-methyl-2-furyl)ethenyl]-s-triazine, 2,4-bis(trichloromethyl)-6-[2-(5-ethyl-2-furyl)ethenyl]-s-triazine, 2,4-bis(trichloromethyl)-6-[2-(5-propyl-2-furyl)ethenyl]-s-triazine, 2,4-bis(trichloromethyl)-6-[2-(3,5-dimethoxyphenyl)ethenyl]-s-triazine, 2,4-bis(trichloromethyl)-6-[2-(3,5-diethoxyphenyl)ethenyl]-s-triazine, 2,4-bis(trichloromethyl)-6-[2-(3,5-dipropoxyphenyl)ethenyl]-s-triazine, 2,4-bis(trichloromethyl)-6-[2-(3-methoxy-5-ethoxyphenyl)ethenyl]-s-triazine, 2,4-bis(trichloromethyl)-6-[2-(3-methoxy-5-propoxyphenyl)ethenyl]-s-triazine, 2,4-bis(trichloromethyl)-6-[2-(3,4-methylenedioxyphenyl)ethenyl]-s-triazine, 2,4-bis(trichloromethyl)-6-(3,4-methylenedioxyphenyl)-s-triazine, 2,4-bis-trichloromethyl-6-(3-bromo-4-methoxy)phenyl-s-triazine, 2,4-bis-trichloromethyl-6-(2-bromo-4-methoxy)phenyl-s-triazine, 2,4-bis-trichloromethyl-6-(2-bromo-4-methoxy)styrylphenyl-s-triazine, 2,4-bis-trichloromethyl-6-(3-bromo-4-methoxy)styrylphenyl-s-triazine, 2-(4-methoxyphenyl)-4,6-bis(trichloromethyl)-1,3,5-triazine, 2-(4-methoxynaphthyl)-4,6-bis(trichloromethyl)-1,3,5-triazine, 2-[2-(2-furyl)ethenyl]-4,6-bis(trichloromethyl)-1,3,5-triazine, 2-[2-(5-methyl-2-furyl)ethenyl]-4,6-bis(trichloromethyl)-1,3,5-triazine, 2-[2-(3,5-dimethoxyphenyl)ethenyl]-4,6-bis(trichloromethyl)-1,3,5-triazine, 2-[2-(3,4-dimethoxyphenyl)ethenyl]-4,6-bis(trichloromethyl)-1,3,5-triazine, 2-(3,4-methylenedioxyphenyl)-4,6-bis(trichloromethyl)-1,3,5-triazine, tris(1,3-dibromopropyl)-1,3,5-triazine and tris(2,3-dibromopropyl)-1,3,5-triazine, and halogen-containing triazine compounds represented by the following formula (a3) such as tris(2,3-dibromopropyl)isocyanurate.

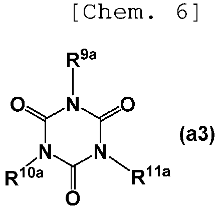

In the above formula (a3), R^{9a}, R^{10a}, and R^{11a} each independently represent a halogenated alkyl group.

Further, the third aspect of the acid generator (A) include α-(p-toluenesulfonyloxyimino)-phenylacetonitrile, α-(benzenesulfonyloxyimino)-2,4-dichlorophenylacetonitrile, α-(benzenesulfonyloxyimino)-2,6-dichlorophenylacetonitrile, α-(2-chlorobenzenesulfonyloxyimino)-4-methoxyphenylacetonitrile and α-(ethylsulfonyloxyimino)-1-cyclopentenylacetonitrile, and compounds represented by the following formula (a4) having an oximesulfonate group.

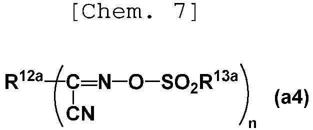

In the above formula (a4), R^{12a} represents a monovalent, bivalent or trivalent organic group, R^{13a} represents a substituted or unsubstituted saturated hydrocarbon group, an unsaturated hydrocarbon group, or an aromatic group, and n represents the number of repeating units of the structure in the parentheses.

In the formula (a4), examples of the aromatic group include aryl groups such as a phenyl group and a naphthyl group, and heteroaryl groups such as a furyl group and a thienyl group. These may have one or more appropriate substituents such as halogen atoms, alkyl groups, alkoxy groups and nitro groups on the rings. It is particularly preferable that R^{13a} is an alkyl group having 1 or more and 6 or less carbon atoms such as a methyl group, an ethyl group, a propyl group, and a butyl group. In particular, compounds in which R^{12a} represents an aromatic group, and R^{13a} represents an alkyl group having 1 or more and 4 or less carbon atoms are preferred.

Examples of the acid generator represented by the above formula (a4) include compounds in which R^{12a} is any one of a phenyl group, a methylphenyl group and a methoxyphenyl group, and R^{13a} is a methyl group, provided that n is 1, and specific examples thereof include α-(methylsulfonyloxyimino)-1-phenylacetonitrile, α-(methylsulfonyloxyimino)-1-(p-methylphenyl)acetonitrile, α-(methylsulfonyloxyimino)-1-(p-methoxyphenyl)acetonitrile,[2-(propylsulfonyloxyimino)-2,3-dihydroxythiophene-3-ylidene](o-tolyl)acetonitrile and the like. Provided that n is 2, the acid generator represented by the above formula (a4) is specifically an acid generator represented by the following formulae.

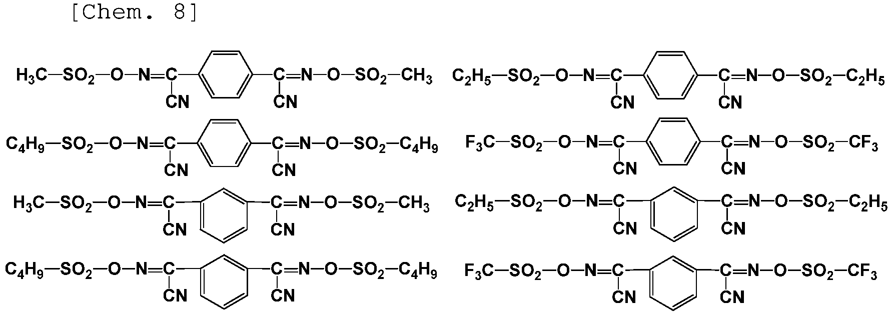

In addition, the fourth aspect of the acid generator (A) include onium salts that have a naphthalene ring at their cation moiety. The expression "have a naphthalene ring" indicates having a structure derived from naphthalene and also indicates at least two ring structures and their aromatic properties are maintained. The naphthalene ring may have a substituent such as a linear or branched alkyl group having 1 or more and 6 or less carbon atoms, a hydroxyl group, a linear or branched alkoxy group having 1 or more and 6 or less carbon atoms or the like. The structure derived from the naphthalene ring, which may be of a monovalent group (one free valance) or of a bivalent group (two free valences), is desirably of a monovalent group (in this regard, the number of free valance is counted except for the portions connecting with the substituents described above). The number of naphthalene rings is preferably 1 or more and 3 or less.

Preferably, the cation moiety of the onium salt having a naphthalene ring at the cation moiety is of the structure represented by the following formula (a5).

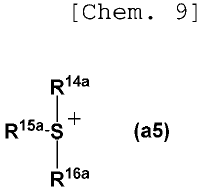

In the above formula (a5), at least one of R^{14a}, R^{15a} and R^{16a} represents a group represented by the following formula (a6), and the remaining represents a linear or branched alkyl group having 1 or more and 6 or less carbon atoms, a phenyl group optionally having a substituent, a hydroxyl group, or a linear or branched alkoxy group having 1 or more and 6 or less carbon atoms. Alternatively, one of R^{14a}, R^{15a} and R^{16a} is a group represented by the following formula (a6), and the remaining two are each independently a linear or branched alkylene group having 1 or more and 6 or less carbon atoms, and these terminals may bond to form a ring structure.

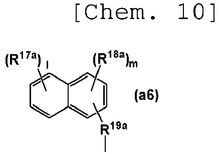

In the formula (a6), R^{17a} and R^{18a} each independently represent a hydroxyl group, a linear or branched alkoxy group having 1 or more and 6 or less carbon atoms, or a linear or branched alkyl group having 1 or more and 6 or less carbon atoms, and R^{19a} represents a single bond or a linear or branched alkylene group having 1 or more and 6 or less carbon atoms that may have a substituent. 1 and m each independently represent an integer of 0 or more and 2 or less, and 1 + m is 3 or less. Herein, when there exists a plurality of R^{17a}, they may be identical to or different from each other. Furthermore, when there exists a plurality of R^{18a}, they may be identical to or different from each other.

Preferably, among R^{14a}, R^{15a} and R^{16a} as above, the number of groups represented by the above formula (a6) is one in view of the stability of the compound, and the remaining are linear or branched alkylene groups having 1 or more and 6 or less carbon atoms of which the terminals may bond to form a ring. In this case, the two alkylene groups described above form a 3 to 9 membered ring including sulfur atom(s). Preferably, the number of atoms to form the ring (including sulfur atom(s)) is 5 or more and 6 or less.

Examples of the substituent, which the alkylene group may have, include an oxygen atom (in this case, a carbonyl group is formed together with a carbon atom that constitutes the alkylene group), a hydroxyl group or the like.

Furthermore, examples of the substituent, which the phenyl group may have, include a hydroxyl group, a linear or branched alkoxy group having 1 or more and 6 or less carbon atoms, a linear or branched alkyl group having 1 or more and 6 or less carbon atoms, or the like.

Examples of suitable cations for the suitable cation moiety include cations represented by the following formulae (a7) and (a8), and the structure represented by the following formula (a8) is particularly preferable.

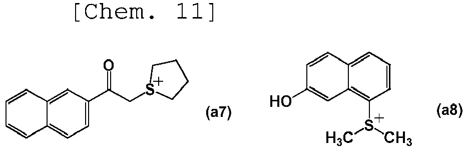

The cation moieties, which may be of an iodonium salt or a sulfonium salt, are desirably of a sulfonium salt in view of acid-producing efficiency.

It is, therefore, desirable that the suitable anions for the anion moiety of the onium salt having a naphthalene ring at the cation moiety is an anion capable of forming a sulfonium salt.

The anion moiety of the acid generator is exemplified by fluoroalkylsulfonic acid ions or aryl sulfonic acid ions, of which hydrogen atom(s) being partially or entirely fluorinated.

The alkyl group of the fluoroalkylsulfonic acid ions may be linear, branched or cyclic and have 1 or more and 20 or less carbon atoms. Preferably, the carbon number is 1 or more and 10 or less in view of bulkiness and diffusion distance of the produced acid. In particular, branched or cyclic alkyl groups are preferable due to shorter diffusion length. Also, methyl, ethyl, propyl, butyl, octyl groups and the like are preferable due to being inexpensively synthesizable.

The aryl group of the aryl sulfonic acid ions may be an aryl group having 6 or more and 20 or less carbon atoms, and is exemplified by a phenol group or a naphthyl group that may be unsubstituted or substituted with an alkyl group or a halogen atom. In particular, aryl groups having 6 or more and 10 or less carbon atoms are preferable due to being inexpensively synthesizable. Specific examples of preferable aryl group include phenyl, toluenesulfonyl, ethylphenyl, naphthyl, methylnaphthyl groups and the like.

When hydrogen atoms in the above fluoroalkylsulfonic acid ion or the aryl sulfonic acid ion are partially or entirely substituted with a fluorine atom, the fluorination rate is preferably 10% or more and 100% or less, and more preferably 50% or more and 100% or less; it is particularly preferable that all hydrogen atoms are each substituted with a fluorine atom in view of higher acid strength. Specific examples thereof include trifluoromethane sulfonate, perfluorobutane sulfonate, perfluorooctane sulfonate, perfluorobenzene sulfonate, and the like.

Among these, the preferable anion moiety is exemplified by those represented by the following formula (a9).

[Chem. 12] R^{20a}SO₃⁻ (a9)

In the above formula (a9), R^{20a} represents groups represented by the following formulae (a10), (a11), and (a12).

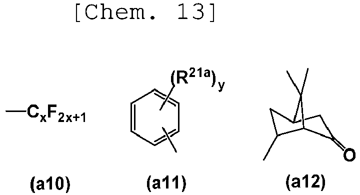

In the above formula (a10), x represents an integer of 1 or more and 4 or less. Also, in the above formula (a11), R^{21a} represents a hydrogen atom, a hydroxyl group, a linear or branched alkyl group having 1 or more and 6 or less carbon atoms, or a linear or branched alkoxy group having 1 or more and 6 or less carbon atoms, and y represents an integer of 1 or more and 3 or less. Of these, trifluoromethane sulfonate, and perfluorobutane sulfonate are preferable in view of safety.

In addition, a nitrogen-containing anion moiety represented by the following formulae (a13) and (a14) may also be used for the anion moiety.

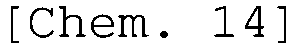

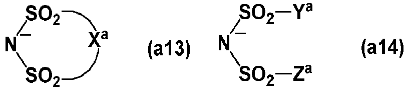

In the formulae (a13) and (a14), X^{a} represents a linear or branched alkylene group in which at least one hydrogen atom is substituted with a fluorine atom, the carbon number of the alkylene group is 2 or more and 6 or less, preferably 3 or more and 5 or less, and most preferably the carbon number is 3. In addition, Y^{a} and Z^{a} each independently represent a linear or branched alkyl group of which at least one hydrogen atom is substituted with a fluorine atom, the number of carbon atoms of the alkyl group is 1 or more and 10 or less, preferably 1 or more and 7 or less, and more preferably 1 or more and 3 or less.

The smaller number of carbon atoms in the alkylene group of X^{a}, or in the alkyl group of Y^{a} or Z^{a} is preferred since the solubility into organic solvent is favorable.

In addition, a larger number of hydrogen atoms each substituted with a fluorine atom in the alkylene group of X^{a}, or in the alkyl group of Y^{a} or Z^{a} is preferred since the acid strength becomes greater. The percentage of fluorine atoms in the alkylene group or alkyl group, i.e., the fluorination rate is preferably 70% or more and 100% or less and more preferably 90% or more and 100% or less, and most preferable are perfluoroalkylene or perfluoroalkyl groups in which all of the hydrogen atoms are each substituted with a fluorine atom.

Examples of preferable compounds for onium salts having a naphthalene ring at their cation moieties include compounds represented by the following formulae (a15) and (a16).

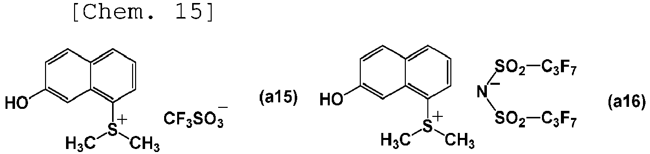

Also, the fifth aspect of the acid generator (A) include bissulfonyldiazomethanes such as bis(p-toluenesulfonyl)diazomethane, bis(1,1-dimethyl ethylsulfonyl)diazomethane, bis(cyclohexylsulfonyl)diazomethane and bis(2,4-dimethylphenylsulfonyl)diazomethane; nitrobenzyl derivatives such as 2-nitrobenzyl p-toluenesulfonate, 2,6-dinitrobenzyl p-toluenesulfonate, nitrobenzyl tosylate, dinitrobenzyl tosylate, nitrobenzyl sulfonate, nitrobenzyl carbonate and dinitrobenzyl carbonate; sulfonates such as pyrogalloltrimesylate, pyrogalloltritosylate, benzyltosylate, benzylsulfonate, N-methylsulfonyloxysuccinimide, N-trichloromethylsulfonyloxysuccinimide, N-phenylsulfonyloxymaleimide and N-methylsulfonyloxyphthalimide; trifluoromethane sulfonates such as N-(trifluoromethylsulfonyloxy)phthalimide, N-(trifluoromethylsulfonyloxy)-1,8-naphthalimide and N-(trifluoromethylsulfonyloxy)-4-butyl-1,8-naphthalimide; onium salts such as diphenyliodonium hexafluorophosphate, (4-methoxyphenyl)phenyliodonium trifluoromethanesulfonate, bis(p-tert-butylphenyl)iodonium trifluoromethanesulfonate, triphenylsulfonium hexafluorophosphate, (4-methoxyphenyl)diphenylsulfonium trifluoromethanesulfonate and (p-tert-butylphenyl)diphenylsulfonium trifluoromethanesulfonate; benzointosylates such as benzointosylate and α-methylbenzointosylate; other diphenyliodonium salts, triphenylsulfonium salts, phenyldiazonium salts, benzylcarbonates and the like.

This acid generator (A) may be used alone, or two or more types may be used in combination. Furthermore, the content of the acid generator (A) is adjusted to preferably 0.1% by mass or more and 10% by mass or less and more preferably 0.5% by mass or more and 3% by mass or less, relative to the total mass of the solid component of the chemically amplified positive-type photosensitive composition. When the amount of the acid generator (A) used is adjusted to the range mentioned above, it is easy to prepare a chemically amplified positive-type photosensitive composition which is a uniform solution having satisfactory sensitivity and excellent storage stability.

### [Resin (B)]

A resin (B) whose solubility in alkali increases under the action of acid is not particularly limited any resins whose solubility in alkali increases under the action of acid can be used. Among them, it is preferable to contain at least one resin selected from the group consisting of a novolak resin (B1), a polyhydroxystyrene resin (B2), and an acrylic resin (B3) .

### (Novolak resin (B1))

As the novolak resin (B1), a resin including the constituent unit represented by the following formula (b1) may be used.

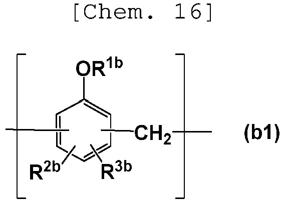

In the formula (b1), R^{1b} represents an acid-dissociable dissolution-inhibiting group, and R^{2b} and R^{3b} each independently represent a hydrogen atom or an alkyl group having 1 or more and 6 or less carbon atoms.

The acid-dissociable dissolution-inhibiting group represented by the above R^{1b} is preferably a group represented by the following formula (b2) or (b3), a linear, branched or cyclic alkyl group having 1 or more and 6 or less carbon atoms, a vinyloxyethyl group, a tetrahydropyranyl group, a tetrahydrofuranyl group, or a trialkylsilyl group.

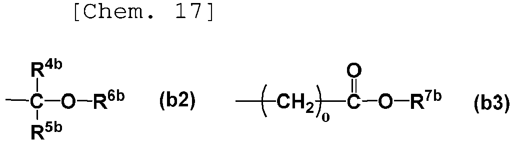

In the above formulae (b2) and (b3), R^{4b} and R^{5b} each independently represent a hydrogen atom, or a linear or branched alkyl group having 1 or more and 6 or less carbon atoms, R^{6b} represents a linear, branched or cyclic alkyl group having 1 or more and 10 or less carbon atoms, R^{7b} represents a linear, branched or cyclic alkyl group having 1 or more and 6 or less carbon atoms, and o represents 0 or 1.

Examples of the above linear or branched alkyl group include a methyl group, an ethyl group, a propyl group, an isopropyl group, an n-butyl group, an isobutyl group, a tert-butyl group, a pentyl group, an isopentyl group, a neopentyl group, and the like. Also, examples of the above cyclic alkyl group include a cyclopentyl group, a cyclohexyl group, and the like.

Specific examples of the acid-dissociable dissolution-inhibiting group represented by the above formula (b2) include a methoxyethyl group, ethoxyethyl group, n-propoxyethyl group, isopropoxyethyl group, n-butoxyethyl group, isobutoxyethyl group, tert-butoxyethyl group, cyclohexyloxyethyl group, methoxypropyl group, ethoxypropyl group, 1-methoxy-1-methylethyl group, 1-ethoxy-1-methylethyl group, and the like. Furthermore, specific examples of the acid-dissociable dissolution-inhibiting group represented by the above formula (b3) include a tert-butoxycarbonyl group, a tert-butoxycarbonylmethyl group, and the like. Examples of the above trialkylsilyl group include a trimethylsilyl group and tri-tert-butyldimethylsilyl group in which each alkyl group has 1 or more and 6 or less carbon atoms.

### (Polyhydroxystyrene resin (B2))

As the polyhydroxystyrene resin (B2), a resin including a constituent unit represented by the following formula (b4) may be used.

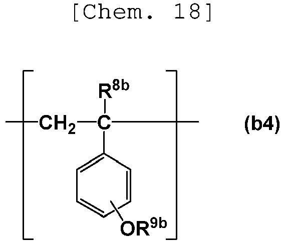

In the above formula (b4), R^{8b} represents a hydrogen atom or an alkyl group having 1 or more and 6 or less carbon atoms, and R^{9b} represents an acid-dissociable dissolution-inhibiting group.

The above alkyl group having 1 or more and 6 or less carbon atoms may include, for example, linear, branched or cyclic alkyl groups having 1 or more and 6 or less carbon atoms. Examples of the linear or branched alkyl group include a methyl group, ethyl group, propyl group, isopropyl group, n-butyl group, isobutyl group, tert-butyl group, pentyl group, isopentyl group, neopentyl group, and the like. Examples of the cyclic alkyl group include a cyclopentyl group and cyclohexyl group.

The acid-dissociable dissolution-inhibiting group represented by the above R^{9b} may be similar to the acid-dissociable dissolution-inhibiting group exemplified in terms of the above formulae (b2) and (b3).

Furthermore, the polyhydroxystyrene resin (B2) may include another polymerizable compound as a constituent unit in order to moderately control physical or chemical properties. The polymerizable compound is exemplified by conventional radical polymerizable compounds and anion polymerizable compounds. Examples of the polymerizable compound include monocarboxylic acids such as acrylic acid, methacrylic acid and crotonic acid; dicarboxylic acids such as maleic acid, fumaric acid and itaconic acid; methacrylic acid derivatives having a carboxyl group and an ester bond such as 2-methacryloyloxyethyl succinic acid, 2-methacryloyloxyethyl maleic acid, 2-methacryloyloxyethyl phthalic acid and 2-methacryloyloxyethyl hexahydrophthalic acid; (meth)acrylic acid alkyl esters such as methyl(meth)acrylate, ethyl (meth)acrylate and butyl (meth)acrylate; (meth)acrylic acid hydroxyalkyl esters such as 2-hydroxyethyl (meth)acrylate and 2-hydroxypropyl (meth)acrylate; (meth)acrylic acid aryl esters such as phenyl (meth)acrylate and benzyl (meth)acrylate; dicarboxylic acid diesters such as diethyl maleate and dibutyl fumarate; vinyl group-containing aromatic compounds such as styrene, α-methylstyrene, chlorostyrene, chloromethylstyrene, vinyltoluene, hydroxystyrene, α-methylhydroxystyrene and α-ethylhydroxystyrene; vinyl group-containing aliphatic compounds such as vinyl acetate; conjugated diolefins such as butadiene and isoprene; nitrile group-containing polymerizable compounds such as acrylonitrile and methacrylonitrile; chlorine-containing polymerizable compounds such as vinyl chloride and vinylidene chloride; and amide bond-containing polymerizable compounds such as acrylamide and methacrylamide.

### (Acrylic resin (B3))

An acrylic resin (B3) is not particularly limited as long as it is an acrylic resin the solubility of which in alkali increases under the action of acid, and has conventionally blended in various photosensitive compositions. Preferably, the acrylic resin (B3) contains a constituent unit (b-3) derived from, for example, an acrylic ester including an -SO₂-containing cyclic group or a lactone-containing cyclic group. In such a case, when a resist pattern is formed, a resist pattern having a preferable cross-sectional shape can be easily formed.

### -SO₂-containing cyclic group

Herein, the "-SO₂-containing cyclic group" refers to a cyclic group having a cyclic group containing a ring including -SO₂- in the ring skeleton thereof, specifically a cyclic group in which the sulfur atom (S) in -SO₂- forms a part of the ring skeleton of the cyclic group. Considering a ring including - SO₂- in the ring skeleton thereof as the first ring, a group having that ring alone is called a monocyclic group, and a group further having another ring structure is called a polycyclic group regardless of its structure. The -SO₂-containing cyclic group may be monocyclic or polycyclic.

In particular, the -SO₂-containing cyclic group is preferably a cyclic group containing -O-SO₂- in the ring skeleton thereof, i.e., a cyclic group containing a sultone ring in which -O-S- in -O-SO₂- forms a part of the ring skeleton.

The number of carbon atoms in an -SO₂-containing cyclic group is preferably 3 or more and 30 or less, more preferably 4 or more and 20 or less, even more preferably 4 or more and 15 or less, and in particular preferably 4 or more and 12 or less. The above number of carbon atoms is the number of carbon atoms constituting a ring skeleton, and shall not include the number of carbon atoms in a substituent.

The -SO₂-containing cyclic group may be an -SO₂-containing aliphatic cyclic group or an -SO₂-containing aromatic cyclic group. It is preferably an -SO₂-containing aliphatic cyclic group.

-SO₂- containing aliphatic cyclic groups include a group in which at least one hydrogen atom is removed from an aliphatic hydrocarbon ring where a part of the carbon atoms constituting the ring skeleton thereof is(are) substituted with -SO₂- or -O-SO₂-. More specifically, they include a group in which at least one hydrogen atom is removed from an aliphatic hydrocarbon ring where -CH₂- constituting the ring skeleton thereof is substituted with -SO₂- and a group in which at least one hydrogen atom is removed from an aliphatic hydrocarbon ring where -CH₂-CH₂- constituting the ring thereof is substituted with -O-SO₂-.

The number of carbon atoms in the above alicyclic hydrocarbon ring is preferably 3 or more and 20 or less, more preferably 3 or more and 12 or less. The above alicyclic hydrocarbon ring may be polycyclic, or may be monocyclic. As the monocyclic alicyclic hydrocarbon group, preferred is a group in which two hydrogen atoms are removed from monocycloalkane having 3 or more and 6 or less carbon atoms. Examples of the above monocycloalkane can include cyclopentane, cyclohexane and the like. As the polycyclic alicyclic hydrocarbon ring, preferred is a group in which two hydrogen atoms are removed from polycycloalkane having 7 or more and 12 or less carbon atoms, and specific examples of the above polycycloalkane include adamantane, norbornane, isobornane, tricyclodecane, tetracyclododecane and the like.

The -SO₂-containing cyclic group may have a substituent. Examples of the above substituent include, for example, an alkyl group, an alkoxy group, a halogen atom, a halogenated alkyl group, a hydroxyl group, an oxygen atom (=O), -COOR", - OC(=O)R", a hydroxyalkyl group, a cyano group and the like.

For an alkyl group as the above substituent, preferred is an alkyl group having 1 or more and 6 or less carbon atoms. The above alkyl group is preferably linear or branched. Specific examples include a methyl group, an ethyl group, an n-propyl group, an isopropyl group, an n-butyl group, an isobutyl group, a tert-butyl group, an n-pentyl group, an isopentyl group, a neopentyl group, an n-hexyl group and the like. Among these, a methyl group or an ethyl group is preferred, and a methyl group is particularly preferred.

For an alkoxy group as the above substituent, preferred is an alkoxy group having 1 or more and 6 or less carbon atoms. The above alkoxy group is preferably linear or branched. Specific examples include a group in which an alkyl groups recited as an alkyl group for the above substituent is attached to the oxygen atom (-O-).

Halogen atoms as the above substituent include a fluorine atom, a chlorine atom, a bromine atom, an iodine atom and the like, and a fluorine atom is preferred.

Halogenated alkyl groups for the above substituent include a group in which a part or all of the hydrogen atoms in the above alkyl group is(are) substituted with the above halogen atom(s).

Halogenated alkyl groups as the above substituent include a group in which a part or all of the hydrogen atoms in the alkyl groups recited as an alkyl group for the above substituent is (are) substituted with the above halogen atom(s). As the above halogenated alkyl group, a fluorinated alkyl group is preferred, and a perfluoroalkyl group is particularly preferred.

R"s in the aforementioned -COOR" and -OC(=O)R" are either a hydrogen atom or a linear, branched or cyclic alkyl group having 1 or more and 15 or less carbon atoms.

In a case where R" is a linear or branched alkyl group, the number of carbon atoms in the above chain alkyl group is preferably 1 or more and 10 or less, more preferably 1 or more and 5 or less, and in particular preferably 1 or 2.

In a case where R" is a cyclic alkyl group, the number of carbon atoms in the above cyclic alkyl group is preferably 3 or more and 15 or less, more preferably 4 or more and 12 or less, and in particular preferably 5 or more and 10 or less. Specific examples can include a group in which one or more hydrogen atoms are removed from monocycloalkane; and polycycloalkane such as bicycloalkane, tricycloalkane, tetracycloalkane and the like optionally substituted with a fluorine atom or a fluorinated alkyl group. More specific examples include a group in which one or more hydrogen atoms are removed from monocycloalkane such as cyclopentane and cyclohexane; and polycycloalkane such as adamantane, norbornane, isobornane, tricyclodecane and tetracyclododecane.

For a hydroxyalkyl group as the above substituent, preferred is a hydroxyalkyl group having 1 or more and 6 or less carbon atoms. Specific examples include a group in which at least one of the hydrogen atoms in the alkyl groups recited as an alkyl group for the above substituent is substituted with a hydroxyl group.

More specific examples of the -SO₂-containing cyclic group include the groups represented by the following formulae (3-1) to (3-4). 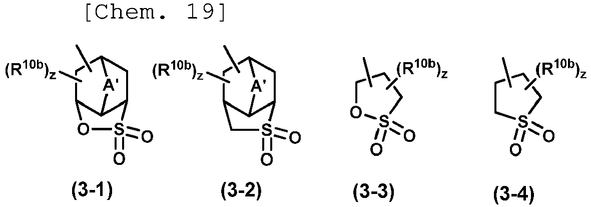 (In the formulae, A' represents an alkylene group having 1 or more and 5 or less carbon atoms optionally including an oxygen atom or a sulfur atom, an oxygen atom or a sulfur atom; z represents an integer of 0 or more and 2 or less; R^{10b} represents an alkyl group, an alkoxy group, a halogenated alkyl group, a hydroxyl group, -COOR", -OC(=O)R", a hydroxyalkyl group, or a cyano group; and R" represents a hydrogen atom or an alkyl group.)

In the above formulae (3-1) to (3-4), A' represents an alkylene group having 1 or more and 5 or less carbon atoms optionally including an oxygen atom (-O-) or a sulfur atom (-S-), an oxygen atom or a sulfur atom. As an alkylene group having 1 or more and 5 or less carbon atoms in A', a linear or branched alkylene group is preferred, and examples thereof include a methylene group, an ethylene group, an n-propylene group, an isopropylene group and the like.

In a case where the above alkylene group includes an oxygen atom or a sulfur atom, specific examples thereof include a group in which -O- or -S- is present at a terminal or between carbon atoms of the above alkylene group, for example, -O-CH₂-, -CH₂-O-CH₂-, -S-CH₂-, -CH₂-S-CH₂-, and the like. As A', an alkylene group having 1 or more and 5 or less carbon atoms or -O- is preferred, and an alkylene group having 1 or more and 5 or less carbon atoms is more preferred, and a methylene group is most preferred.

z may be any of 0, 1, and 2, and is most preferably 0. I n a case where z is 2, a plurality of R^{10b} may be the same, or may differ from each other.

An alkyl group, an alkoxy group, an halogenated alkyl group, -COOR", -OC(=O)R" and a hydroxyalkyl group in R^{10b} include those similar to the groups described above for the alkyl group, the alkoxy group, the halogenated alkyl group, - COOR", -OC(=O)R" and the hydroxyalkyl group, respectively, which are recited as those optionally contained in the -SO₂-containing cyclic group.

Below, specific cyclic groups represented by the above formulae (3-1) to (3-4) will be illustrated. Note here that "Ac" in the formulae represents an acetyl group.

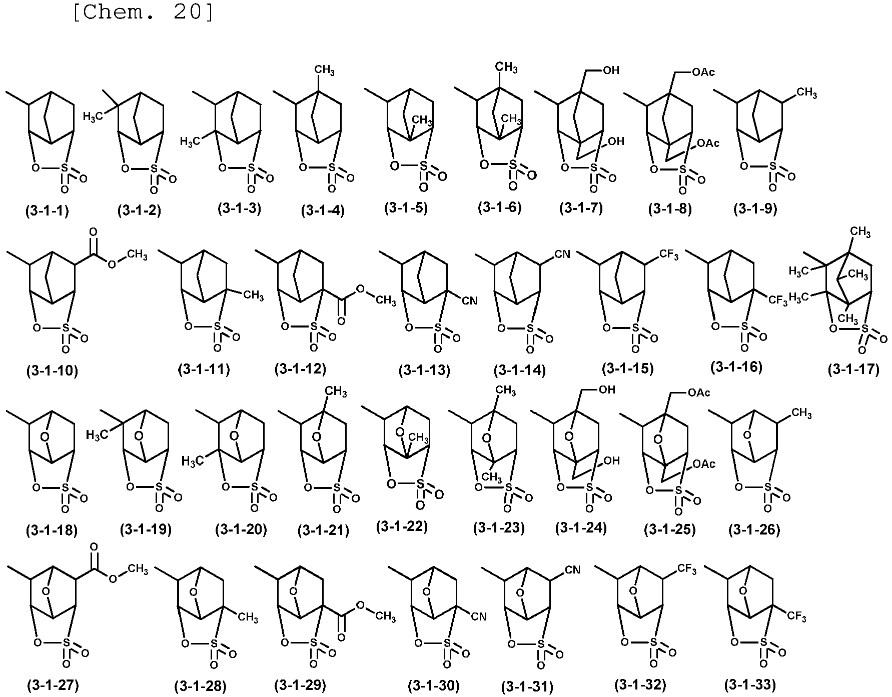

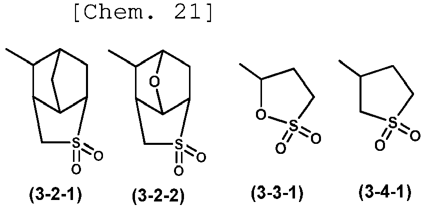

As the -SO₂-containing cyclic group, among those shown above, a group represented by the above formula (3-1) is preferred, and at least one selected from the group consisting of the groups represented by any of the aforementioned formulae (3-1-1), (3-1-18), (3-3-1) and (3-4-1) is more preferred, and a group represented by the aforementioned formula (3-1-1) is most preferred.

### Lactone-containing cyclic group

The "lactone-containing cyclic group" refers to a cyclic group containing a ring (lactone ring) including -O-C(=O)- in the ring skeleton thereof. Considering the lactone ring as the first ring, a group having that lactone ring alone is called a monocyclic group, and a group further having another ring structure is called a polycyclic group regardless of its structure. The lactone-containing cyclic group may be a monocyclic group, or may be a polycyclic group.

There is no particular limitation on the lactone cyclic group in the constituent unit (b-3), and any cyclic group containing the lactone ring can be used. Specifically, examples of the lactone-containing monocyclic groups include a group in which one hydrogen atom is removed from 4 to 6 membered ring lactone, for example, a group in which one hydrogen atom is removed from β-propiono lactone, a group in which one hydrogen atom is removed from γ-butyrolactone, a group in which one hydrogen atom is removed from δ-valerolactone and the like. Further, lactone-containing polycyclic groups include a group in which one hydrogen atom is removed from bicycloalkane, tricycloalkane and tetracycloalkane having a lactone ring.

As to the constituent unit (b-3), as long as the constituent unit (b-3) has an -SO₂-containing cyclic group or a lactone-containing cyclic group, the structures of other parts are not particularly limited. A preferred constituent unit (b-3) is at least one constituent unit selected from the group consisting of a constituent unit (b-3-S) derived from an acrylic acid ester including an -SO₂-containing cyclic group in which a hydrogen atom attached to the carbon atom in the α position may be substituted with a substituent; and a constituent unit (b-3-L) derived from an acrylic acid ester including a lactone-containing cyclic group in which the hydrogen atom attached to the carbon atom in the α position may be substituted with a substituent.

### Constituent unit (b-3-S)

More specifically, examples of the constituent unit (b-3-S) include one represented by the following formula (b-S1). 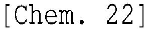 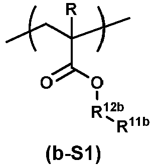 (In the formula, R represents a hydrogen atom, an alkyl group having 1 or more 5 or less carbon atoms or a halogenated alkyl group having 1 or more 5 or less carbon atoms; and R^{11b} represents an -SO₂-containing cyclic group; and R^{12b} represents a single-bond or divalent linking group.)

In the formula (b-S1), R is similarly defined as above. R^{11b} is similarly defined as in the -SO₂-containing cyclic group described above. R^{12b} may be either a single-bond linking group or a divalent linking group.

There is no particular limitation on the divalent linking group in R^{12b}, and suitable groups include an optionally substituted divalent hydrocarbon group, a divalent linking group including a heteroatom, and the like.

### - Optionally substituted divalent hydrocarbon group

The hydrocarbon group as a divalent linking group may be an aliphatic hydrocarbon group, or may be an aromatic hydrocarbon group. The aliphatic hydrocarbon group means a hydrocarbon group without aromaticity. The above aliphatic hydrocarbon group may be saturated or may be unsaturated. Usually, a saturated hydrocarbon group is preferred. More specifically, examples of the above aliphatic hydrocarbon group include a linear or branched aliphatic hydrocarbon group, an aliphatic hydrocarbon group including a ring in the structure thereof and the like.

The number of carbon atoms in the linear or branched aliphatic hydrocarbon group is preferably 1 or more and 10 or less, more preferably 1 or more and 8 or less, and even more preferably 1 or more and 5 or less.

As the linear aliphatic hydrocarbon group, a linear alkylene group is preferred. Specific examples include a methylene group [-CH₂-], an ethylene group [-(CH₂)₂-], a trimethylene group [-(CH₂)₃-], a tetramethylene group [-(CH₂)₄-], a pentamethylene group [-(CH₂)₅-] and the like.

As the branched aliphatic hydrocarbon group, a branched alkylene group is preferred. Specific examples include alkyl alkylene groups such as alkyl methylene groups such as - CH(CH₃)-, -CH(CH₂CH₃)-, -C(CH₃)₂-, -C(CH₃)(CH₂CH₃)-, - C(CH₃)(CH₂CH₂CH₃)- and -C(CH₂CH₃)₂-; alkyl ethylene groups such as -CH(CH₃)CH₂-, -CH(CH₃)CH(CH₃)-, -C(CH₃)₂CH₂-, -CH(CH₂CH₃)CH₂- and -C(CH₂CH₃)₂-CH₂-; alkyl trimethylene groups such as - CH(CH₃)CH₂CH₂- and -CH₂CH(CH₃)CH₂-; alkyl tetramethylene groups such as -CH(CH₃)CH₂CH₂CH₂- and -CH₂CH(CH₃)CH₂CH₂-; and the like. As an alkyl group in the alkyl alkylene group, a linear alkyl group having 1 or more and 5 or less carbon atoms is preferred.

The above linear or branched aliphatic hydrocarbon group may or may not have a substituent (a group or atom other than a hydrogen atom) which substitutes a hydrogen atom. Examples of the substituent include a fluorine atom, a fluorinated alkyl group having 1 or more and 5 or less carbon atoms substituted with a fluorine atom, an oxo group (=O) and the like.

Examples of the above aliphatic hydrocarbon group including a ring in the structure thereof include a cyclic aliphatic hydrocarbon group optionally including a hetero atom in the ring structure (a group in which two hydrogen atoms are removed from an aliphatic hydrocarbon ring); a group in which the above cyclic aliphatic hydrocarbon group is attached to an end of a linear or branched aliphatic hydrocarbon group; a group in which the above cyclic aliphatic hydrocarbon group is present in a linear or branched aliphatic hydrocarbon group along the chain; and the like. Examples of the above linear or branched aliphatic hydrocarbon group include those groups similar to the above.

The number of carbon atoms in the cyclic aliphatic hydrocarbon group is preferably 3 or more and 20 or less, and more preferably 3 or more and 12 or less.

The cyclic aliphatic hydrocarbon group may be polycyclic, or may be monocyclic. As the monocyclic aliphatic hydrocarbon group, a group in which two hydrogen atoms are removed from monocycloalkane is preferred. The number of carbon atoms in the above monocycloalkane is preferably 3 or more and 6 or less. Specific examples include cyclopentane, cyclohexane and the like. As the polycyclic aliphatic hydrocarbon group, a group in which two hydrogen atoms are removed from polycycloalkane is preferred. The number of carbon atoms in the above polycycloalkane is preferably 7 or more and 12 or less. Specific examples include adamantane, norbornane, isobornane, tricyclodecane, tetracyclododecane and the like.

The cyclic aliphatic hydrocarbon group may or may not have a substituent which substitutes a hydrogen atom (a group or atom other than a hydrogen atom). Examples of the above substituent include an alkyl group, an alkoxy group, a halogen atom, a halogenated alkyl group, a hydroxyl group, an oxo group (=O) and the like.

For an alkyl group as the above substituent, an alkyl group having 1 or more and 5 or less carbon atoms is preferred, and a methyl group, an ethyl group, a propyl group, an n-butyl group and a tert-butyl group are more preferred.

For an alkoxy group as the above substituent, an alkoxy group having 1 or more and 5 or less carbon atoms is preferred, and a methoxy group, an ethoxy group, an n-propoxy group, an iso-propoxy group, an n-butoxy group and a tert-butoxy group are more preferred, and a methoxy group and an ethoxy group are particularly preferred.

Halogen atoms as the above substituent include a fluorine atom, a chlorine atom, a bromine atom, an iodine atom and the like, and a fluorine atom is preferred.

Halogenated alkyl groups as the above substituent include a group in which a part or all of hydrogen atoms in the aforementioned alkyl group is(are) substituted with the above halogen atom(s).

In the cyclic aliphatic hydrocarbon group, a part of carbon atoms constituting the ring structure thereof may be substituted with -O-, or -S-. As the substituent including the above hetero atom, preferred are -O-, -C(=O)-O-, -S-, -S(=O)₂-and -S(=O)₂-O-.

The aromatic hydrocarbon group as the divalent hydrocarbon group is a divalent hydrocarbon group having at least one aromatic ring, and may have a substituent. There is no particular limitation on the aromatic ring as long as it is a cyclic conjugated system having a 4n+2 Π electrons, and it may be monocyclic or may be polycyclic. The number of carbon atoms in the aromatic ring is preferably 5 or more and 30 or less, more preferably 5 or more and 20 or less, further more preferably 6 or more and 15 or less, and particularly preferably 6 or more and 12 or less. However, the number of carbon atoms in a substituent shall not be included in the above number of carbon atoms.

Specifically, aromatic rings include aromatic hydrocarbon rings such as benzene, naphthalene, anthracene and phenanthrene; aromatic heterocycles in which a part of the carbon atoms constituting the above aromatic hydrocarbon ring is (are) substituted with hetero atom(s). Hetero atoms in the aromatic heterocycle include an oxygen atom, a sulfur atom, a nitrogen atom and the like. Specifically, aromatic heterocycles include a pyridine ring, a thiophene ring, and the like.

Specific examples of the aromatic hydrocarbon group as a divalent hydrocarbon group include a group in which two hydrogen atoms are removed from the above aromatic hydrocarbon ring or the above aromatic heterocycle (an arylene group or a heteroarylene group); a group in which two hydrogen atoms are removed from an aromatic compound including two or more aromatic rings (for example, biphenyl, fluorene and the like); a group in which one hydrogen atom from a group where one hydrogen atom is removed from the above aromatic hydrocarbon ring or the above aromatic heterocycle (an aryl group or a heteroaryl group) is substituted with an alkylene group (for example, a group in which one hydrogen atom is further removed from an aryl group in an arylalkyl group such as a benzyl group, a phenethyl group, a 1-naphthylmethyl group, a 2-naphthylmethyl group, a 1-naphthylethyl group and a 2-naphthylethyl group); and the like.

The number of carbon atoms in the above alkylene group bonded to an aryl group or a heteroaryl group is preferably 1 or more and 4 or less, more preferably 1 or more and 2 or less, and particularly preferably 1.

In the above aromatic hydrocarbon group, a hydrogen atom of the above aromatic hydrocarbon group may be substituted with a substituent. For example, a hydrogen atom attached to an aromatic ring in the above aromatic hydrocarbon group may be substituted with a substituent. Examples of the substituent include an alkyl group, an alkoxy group, a halogen atom, a halogenated alkyl group, a hydroxyl group, an oxo group (=O) and the like.

For an alkyl group as the above substituent, an alkyl group having 1 or more and 5 or less carbon atoms is preferred, and a methyl group, an ethyl group, an n-propyl group, an n-butyl group and a tert-butyl group are more preferred.

For an alkoxy group as the above substituent, an alkoxy group having 1 or more and 5 or less carbon atoms is preferred, and a methoxy group, an ethoxy group, an n-propoxy group, an iso-propoxy group, an n-butoxy group and a tert-butoxy group are preferred, and a methoxy group and an ethoxy group are more preferred.

Halogen atoms as the above substituent include a fluorine atom, a chlorine atom, a bromine atom, an iodine atom and the like, and a fluorine atom is preferred.

Halogenated alkyl groups as the above substituent include a group in which a part or all of hydrogen atoms in the aforementioned alkyl group is (are) substituted with the above halogen atom(s).

### - Divalent linking group including hetero atom

A hetero atom in the divalent linking group including a hetero atom is an atom other than a carbon atom and a hydrogen atom, and examples thereof include an oxygen atom, a nitrogen atom, a sulfur atom, a halogen atom and the like.

Specific examples of the divalent linking group including a hetero atom include non-hydrocarbon based linking groups such as -O-, -C(=O)-, -C(=O)-O-, -O-C(=O)-O-, -S-, -S(=O)₂-, - S(=O)₂-O-, -NH-, -NH-C(=O)-, -NH-C(=NH)-, =N-, and combinations of at least one of these non-hydrocarbon based linking groups and a divalent hydrocarbon group and the like. Examples of the above divalent hydrocarbon group include those groups similar to the aforementioned divalent hydrocarbon groups optionally having a substituent, and linear or branched aliphatic hydrocarbon groups are preferred.

Among those described above, H in -NH- in -C(=O)-NH-, -NH- and -NH-C(=NH)- may be substituted with a substituent such as an alkyl group or an acyl group, respectively. The number of carbon atoms in the above substituent is preferably 1 or more and 10 or less, more preferably 1 or more and 8 or less, and in particular preferably 1 or more and 5 or less.

As a divalent linking group in R^{12b}, a linear or branched alkylene group, a cyclic aliphatic hydrocarbon group, or a divalent linking group including a hetero atom is preferred.

In a case where the divalent linking group in R^{12b} is a linear or branched alkylene group, the number of carbon atoms in the above alkylene group is preferably 1 or more and 10 or less, more preferably 1 or more and 6 or less, in particular preferably 1 or more and 4 or less, and most preferably 1 or more and 3 or less. Specific examples include groups similar to the linear alkylene groups or branched alkylene groups recited as a linear and branched aliphatic hydrocarbon group in the description of the "divalent hydrocarbon group optionally having a substituent" as the aforementioned divalent linking group.

In a case where the divalent linking group in R^{12b} is a cyclic aliphatic hydrocarbon group, examples of the above cyclic aliphatic hydrocarbon group include groups similar to those recited as the "aliphatic hydrocarbon group including a ring in the structure" in the description of the "divalent hydrocarbon group optionally having a substituent" as the aforementioned divalent linking group.

As the above cyclic aliphatic hydrocarbon group, particularly preferred is a group in which two or more hydrogen atoms are removed from cyclopentane, cyclohexane, norbornane, isobornane, adamantane, tricyclodecane or tetracyclododecane.

In a case where the divalent linking group in R^{12b} is a divalent linking group including a hetero atom, groups preferred as the above linking groups include -O-, -C(=O)-O-, -C(=O)-, -O-C(=O)-O-, -C(=O)-NH-, -NH- (H may be substituted with a substituent such as an alkyl group or an acyl group), - S-, -S(=O)₂-, -S(=O)₂-O- and a group represented by the general formula -Y¹O-Y²-, -[Y¹-C(=O)-O]_{m'}-Y²- or -Y¹-O-C(=O)-Y₂-[wherein Y¹ and Y² are divalent hydrocarbon groups each independently, optionally having a substituent, and O represents an oxygen atom, and m' is an integer of 0 or more and 3 or less.].

In a case where the divalent linking group in R^{12b} is -NH-, the hydrogen atom in -NH- may be substituted with a substituent such as an alkyl group or an acyl group. The number of carbon atoms in the above substituent (an alkyl group, an acyl group and the like) is preferably 1 or more and 10 or less, more preferably 1 or more and 8 or less, and in particular preferably 1 or more and 5 or less.

Y¹ and Y² in the formula Y¹-O-Y²-, -[Y¹-C(=O)-O]_{m'}-Y²- or - Y¹-O-C(=O)-Y²- are divalent hydrocarbon groups each independently, optionally having a substituent. Examples of the above divalent hydrocarbon group include groups similar to the "divalent hydrocarbon group optionally having a substituent" recited in the description of the above divalent linking group.

As Y¹, a linear aliphatic hydrocarbon group is preferred, and a linear alkylene group is more preferred, and a linear alkylene group having 1 or more and 5 or less carbon atoms is more preferred, and a methylene group and an ethylene group are particularly preferred.

As Y², a linear or branched aliphatic hydrocarbon group is preferred, and a methylene group, an ethylene group and an alkylmethylene group are more preferred. The alkyl group in the above alkylmethylene group is preferably a linear alkyl group having 1 or more and 5 or less carbon atoms, more preferably a linear alkyl group having 1 or more and 3 or less carbon atoms, and particularly preferably a methyl group.

In a group represented by the formula -[Y¹-C(=O)-O]_{m'}-Y²-, m' is an integer of 0 or more and 3 or less, preferably an integer of 0 or more and 2 or less, more preferably 0 or 1, and particularly preferably 1. In other words, as a group represented by the formula -[Y¹-C(=O)-O]_{m'}-Y²-, a group represented by the formula -Y¹-C(=O)-O-Y²- is particularly preferred. Among these, a group represented by the formula - (CH₂)_{a'}-C(=O)-O-(CH₂)_{b'}- is preferred. In the above formula, a' is an integer of 1 or more and 10 or less, preferably an integer of 1 or more and 8 or less, more preferably an integer of 1 or more and 5 or less, even more preferably 1 or 2, and most preferably 1.
b' is an integer of 1 or more and 10 or less, preferably an integer of 1 or more and 8 or less, more preferably an integer of 1 or more and 5 or less, even more preferably 1 or 2, and most preferably 1.

With regard to the divalent linking group in R^{12b}, an organic group including a combination of at least one non-hydrocarbon group and a divalent hydrocarbon group is preferred as the divalent linking group including a hetero atom. Among these, a linear chain group having an oxygen atom as a hetero atom, for example, a group including an ether bond or an ester bond is preferred, and a group represented by the aforementioned formula -Y¹O-Y²-, -[Y¹-C(=O)-O]_{m'}-Y²- or -Y¹-O-C(=O)-Y²- is more preferred, and a group represented by the aforementioned formula -[Y¹-C(=O)-O]_{m'}-Y²- or -Y¹-O-C(=O)-Y²- is particularly preferred.

As the divalent linking group in R^{12b}, a group including an alkylene group or an ester bond (-C(=O)-O-) is preferred.

The above alkylene group is preferably a linear or branched alkylene group. Suitable examples of the above linear aliphatic hydrocarbon group include a methylene group [-CH₂-], an ethylene group [-(CH₂)₂-], a trimethylene group [-(CH₂)₃-], a tetramethylene group [-(CH₂)₄-], a pentamethylene group [-(CH₂)₅-] and the like. Suitable examples of the above branched alkylene group include alkyl alkylene groups such as alkyl methylene groups such as - CH(CH₃)-, -CH(CH₂CH₃)-, -C(CH₃)₂-, - C(CH₃)(CH₂CH₃)-, -C(CH₃) (CH₂CH₂CH₃)- and -C(CH₂CH₃)₂-; alkyl ethylene groups such as -CH(CH₃) CH₂-, -CH(CH₃) CH(CH₃) -, - C(CH₃)₂CH₂-, -CH(CH₂CH₃)CH₂- and -C(CH₂CH₃)₂-CH₂-; alkyl trimethylene groups such as -CH(CH₃) CH₂CH₂- and -CH₂CH(CH₃) CH₂-; alkyl tetramethylene groups such as -CH(CH₃)CH₂CH₂CH₂- and - CH₂CH(CH₃) CH₂CH₂-.

As the divalent linking group including an ester bond, particularly preferred is a group represented by the formula: -R^{13b}-C(=O)-O- [wherein R^{13b} represents a divalent linking group.]. In other words, the constituent unit (b-3-S) is preferably a constituent unit represented by the following formula (b-S1-1). 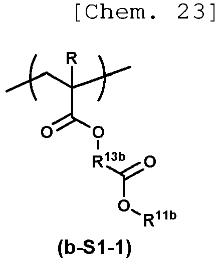 (In the formula, R and R^{11b} are each similar to the above, and R^{13b} represents a divalent linking group.)

There is no particular limitation for R^{13b}, examples thereof include groups similar to the aforementioned divalent linking group in R^{12b}. As the divalent linking group in R^{13b}, a linear or branched alkylene group, an aliphatic hydrocarbon group including a ring in the structure, or a divalent linking group including a hetero atom is preferred, and a linear or branched alkylene group or a divalent linking group including an oxygen atom as a hetero atom is preferred.

As the linear alkylene group, a methylene group or an ethylene group is preferred, and a methylene group is particularly preferred. As the branched alkylene group, an alkylmethylene group or an alkylethylene group is preferred, and -CH(CH₃)-, -C(CH₃)₂- or -C(CH₃)₂CH₂- is particularly preferred.

As the divalent linking group including an oxygen atom, a divalent linking group including an ether bond or an ester bond is preferred, and the aforementioned -Y¹O-Y²-, -[Y¹-C(=O)-O]ₘ'-Y²- or -Y¹-O-C(=O)-Y²- is more preferred. Y¹ and Y² are each independently divalent hydrocarbon groups optionally having a substituent, and m' is an integer of 0 or more and 3 or less. Among these, -Y¹-O-C(=O)-Y²- is preferred, and a group represented by -(CH₂)_{c}-O-C(=O)-(CH₂)_{d}- is particularly preferred. c is an integer of 1 or more and 5 or less, and 1 or 2 is preferred. d is an integer of 1 or more and 5 or less, and 1 or 2 is preferred.

As the constituent unit (b-3-S), in particular, one represented by the following formula (b-S1-11) or (b-Sl-12) is preferred, and one represented by the formula (b-S1-12) is more preferred. 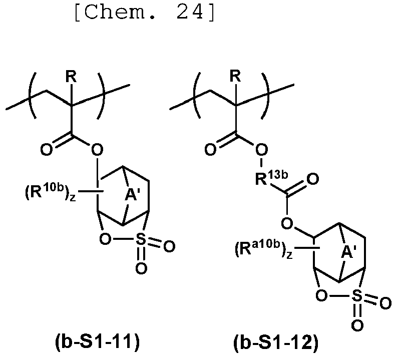 (In the formulae, R, A', R^{10b}, z and R^{13b} are each the same as the above.)

In the formula (b-S1-11), A' is preferably a methylene group, an oxygen atom (-O-) or a sulfur atom (-S-).

As R^{13b}, preferred is a linear or branched alkylene group or a divalent linking group including an oxygen atom. Examples of the linear or branched alkylene group and the divalent linking group including an oxygen atom in R^{13b} include those similar to the aforementioned linear or branched alkylene group and the aforementioned divalent linking group including an oxygen atom, respectively.

As the constituent unit represented by the formula (b-S1-12), particularly preferred is one represented by the following formula (b-S1-12a) or (b-S1-12b). 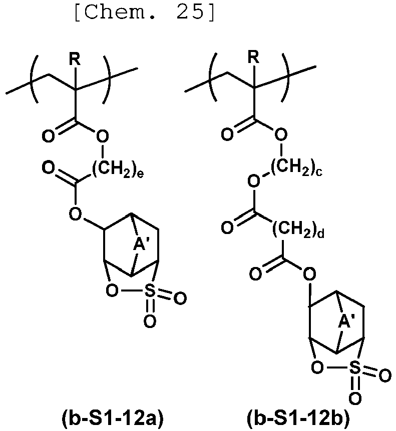 (In the formulae, R and A' are each the same as the above, and c to e are each independently an integer of 1 or more and 3 or less.)

### Constituent unit (b-3-L)

Examples of the constituent unit (b-3-L) include, for example, a constituent unit in which R^{11b} in the aforementioned formula (b-S1) is substituted with a lactone-containing cyclic group. More specifically they include those represented by the following formulae (b-L1) to (b-L5). 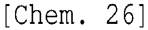 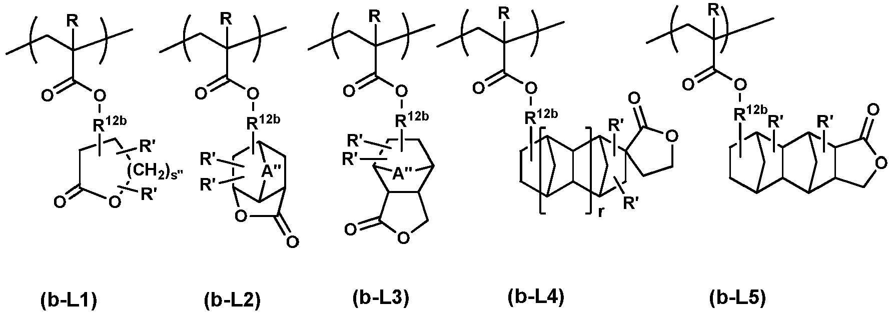 (In the formulae, R represents a hydrogen atom, an alkyl group having 1 or more and 5 or less carbon atoms or a halogenated alkyl group having 1 or more and 5 or less carbon atoms; R' represents each independently a hydrogen atom, an alkyl group, an alkoxy group, a halogenated alkyl group, a hydroxyl group, -COOR", -OC(=O)R", a hydroxyalkyl group or a cyano group, and R" represents a hydrogen atom or an alkyl group; R^{12b} represents a single bond or divalent linking group, and s" is an integer of 0 or more and 2 or less; A" represents an alkylene group having 1 or more and 5 or less carbon atoms optionally including an oxygen atom or a sulfur atom, an oxygen atom or a sulfur atom; and r is 0 or 1.)

R in the formulae (b-L1) to (b-L5) is the same as the above. Examples of the alkyl group, the alkoxy group, the halogenated alkyl group, -COOR", -OC(=O)R" and the hydroxyalkyl group in R' include groups similar to those described for the alkyl group, the alkoxy group, the halogenated alkyl group, -COOR", -OC(=O)R" and the hydroxyalkyl group recited as a substituent which the -SO₂-containing cyclic group may have, respectively.

R' is preferably a hydrogen atom in view of easy industrial availability and the like. The alkyl group in R" may be any of a linear, branched or cyclic chain. In a case where R" is a linear or branched alkyl group, the number of carbon atoms is preferably 1 or more and 10 or less, and more preferably 1 or more and 5 or less. In a case where R" is a cyclic alkyl group, the number of carbon atoms is preferably 3 or more and 15 or less, more preferably 4 or more and 12 or less, and most preferably 5 or more and 10 or less. Specific examples include a group in which one or more hydrogen atoms are removed from monocycloalkane and polycycloalkane such as bicycloalkane, tricycloalkane, tetracycloalkane and the like optionally substituted with a fluorine atom or a fluorinated alkyl group. Specific examples include a group in which one or more hydrogen atoms are removed from monocycloalkane such as cyclopentane and cyclohexane; and polycycloalkane such as adamantane, norbornane, isobornane, tricyclodecane and tetracyclododecane; and the like. Examples of A" include groups similar to A' in the aforementioned formula (3-1). A" is preferably an alkylene group having 1 to 5 carbon atoms, an oxygen atom (-O-) or a sulfur atom (-S-), more preferably an alkylene group having 1 or more and 5 or less carbon atoms or -O-. As the alkylene group having 1 or more and 5 or less carbon atoms, a methylene group or a dimethylmethylene group is more preferred, and a methylene group is most preferred.

R^{12b} is similar to R^{12b} in the aforementioned formula (b-S1). In the formula (b-L1), s" is preferably 1 or 2. Below, specific examples of the constituent units represented by the aforementioned formulae (b-L1) to (b-L3) will be illustrated. In each of the following formulae, R^{α} represents a hydrogen atom, a methyl group or a trifluoromethyl group.

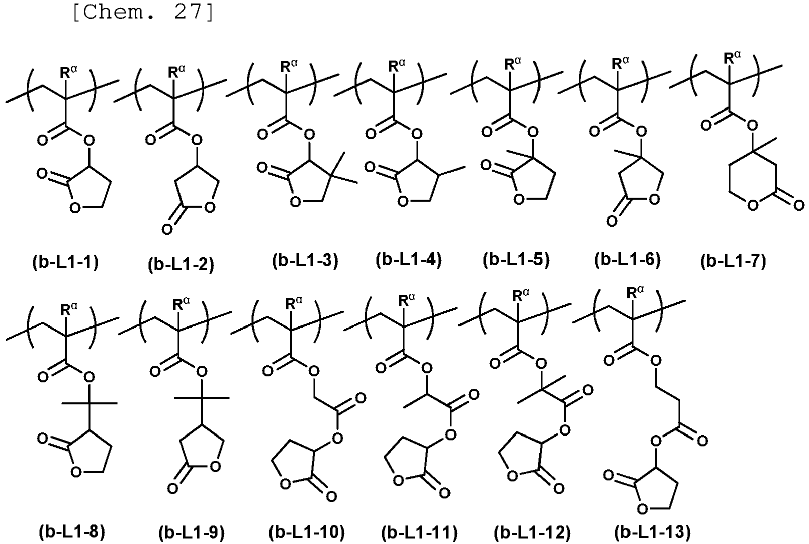

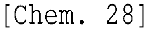

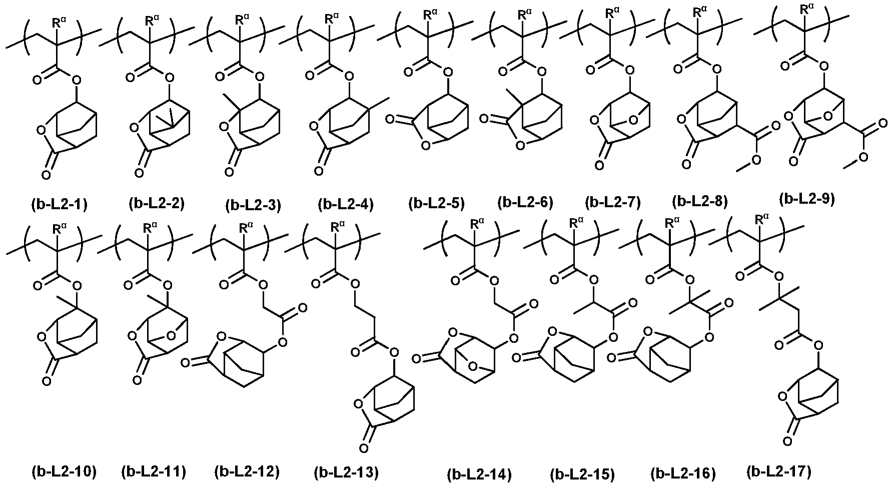

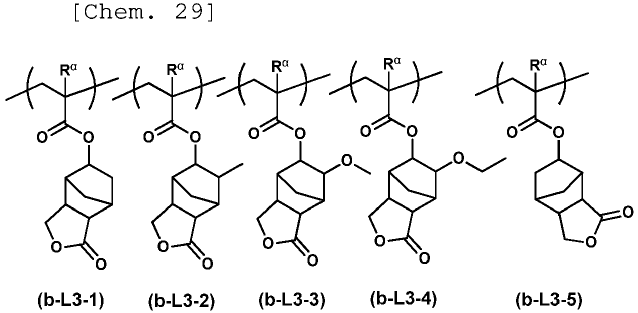

As the constituent unit (b-3a-L), at least one selected from the group consisting of the constituent units represented by the aforementioned formulae (b-L1) to (b-L5) is preferred, and at least one selected from the group consisting of the constituent units represented by the formulae (b-L1) to (b-L3) is more preferred, and at least one selected from the group consisting of the constituent units represented by the aforementioned formula (b-L1) or (b-L3) is particularly preferred. Among these, at least one selected from the group consisting of the constituent units represented by the aforementioned formulae (b-L1-1), (b-L1-2), (b-L2-1), (b-L2-7), (b-L2-12), (b-L2-14), (b-L3-1) and (b-L3-5) is preferred.

Further, as the constituent unit (b-3-L), the constituent units represented by following formulae (b-L6) to (b-L7) are also preferred.

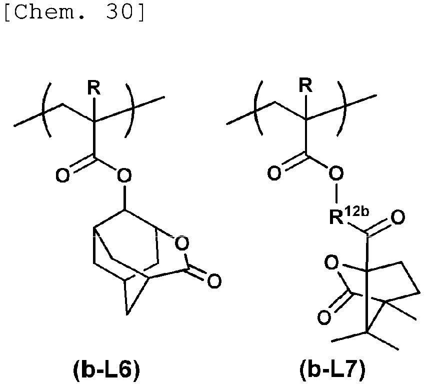

R and R^{12b} in the formulae (b-L6) and (b-L7) are the same as the above.

Further, the acrylic resin (B3) includes constituent units represented by the following formulae (b5) to (b7), having an acid dissociable group, as constituent units that enhance the solubility of the acrylic resin (B3) in alkali under the action of acid.

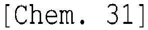

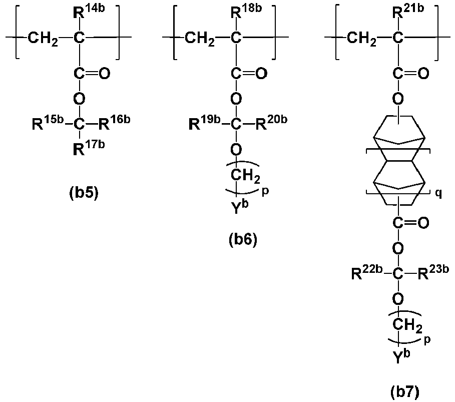

In the above formulae (b5) to (b7), R^{14b} and R^{18b} to R^{23b} each independently represent a hydrogen atom, a linear or branched alkyl group having 1 or more and 6 or less carbon atoms, a fluorine atom, or a linear or branched fluorinated alkyl group having 1 or more and 6 or less carbon atoms; R^{15b} to R^{17b} each independently represent a linear or branched alkyl group having 1 or more and 6 or less carbon atoms, a linear or branched fluorinated alkyl group having 1 or more and 6 or less carbon atoms, or an aliphatic cyclic group having 5 or more and 20 or less carbon atoms, and each independently represent a linear or branched alkyl group having 1 or more and 6 or less carbon atoms, or a linear or branched fluorinated alkyl group having 1 or more and 6 or less carbon atoms; and R^{16b} and R^{17b} may be bonded to each other to form a hydrocarbon ring having 5 or more and 20 or less carbon atoms together with the carbon atom to which both the groups are bonded; Y^{b} represents an optionally substituted aliphatic group or alkyl group; p is an integer of 0 or more and 4 or less; and q is 0 or 1.

Note here that examples of the linear or branched alkyl group include a methyl group, ethyl group, propyl group, isopropyl group, n-butyl group, isobutyl group, tert-butyl group, pentyl group, isopentyl group, neopentyl group, and the like. Furthermore, the fluorinated alkyl group refers to the abovementioned alkyl groups of which the hydrogen atoms are partially or entirely substituted with fluorine atoms. Specific examples of aliphatic cyclic groups include groups obtained by removing one or more hydrogen atoms from monocycloalkanes or polycycloalkanes such as bicycloalkanes, tricycloalkanes, and tetracycloalkanes. Specifically, groups obtained by removing one hydrogen atom from a monocycloalkane such as cyclopentane, cyclohexane, cycloheptane, or cyclooctane, or a polycycloalkane such as adamantane, norbornane, isobornane, tricyclodecane, or tetracyclododecane may be mentioned. In particular, groups obtained by removing one hydrogen atom from cyclohexane or adamantane (which may further be substituted) are preferred.

When R^{16b} and R^{17b} do not combine with each other to form a hydrocarbon ring, the above R^{15b}, R^{16b}, and R^{17b} represent preferably a linear or branched alkyl group having 2 or more and 4 or less carbon atoms, for example, from the viewpoints of a high contrast and favorable resolution and depth of focus. The above R^{19b}, R^{20b}, R^{22b}, and R^{23b} preferably represent a hydrogen atom or a methyl group.

The above R^{16b} and R^{17b} may form an aliphatic cyclic group having 5 or more and 20 or less carbon atoms together with a carbon atom to which the both are attached. Specific examples of such an alicyclic group are the groups of monocycloalkanes and polycycloalkanes such as bicycloalkanes, tricycloalkanes and tetracycloalkanes from which one or more hydrogen atoms are removed. Specific examples thereof are the groups of monocycloalkanes such as cyclopentane, cyclohexane, cycloheptane and cyclooctane and polycycloalkanes such as adamantane, norbornane, isobornane, tricyclodecane and tetracyclododecane from which one or more hydrogen atoms are removed. Particularly preferable are the groups of cyclohexane and adamantane from which one or more hydrogen atoms are removed (that may further have a substituent).

Further, in a case where an aliphatic cyclic group to be formed with the above R^{16b} and R^{17b} has a substituent on the ring skeleton thereof, examples of the substituent include a polar group such as a hydroxyl group, a carboxyl group, a cyano group and an oxygen atom (=O), and a linear or branched alkyl group having 1 or more and 4 or less carbon atoms. As the polar group, an oxygen atom (=O) is particularly preferred.

The above Y^{b} is an alicyclic group or an alkyl group; and examples thereof are the groups of monocycloalkanes and polycycloalkanes such as bicycloalkanes, tricycloalkanes and tetracycloalkanes from which one or more hydrogen atoms are removed. Specific examples thereof are the groups of monocycloalkanes such as cyclopentane, cyclohexane, cycloheptane and cyclooctane, and polycycloalkanes such as adamantane, norbornane, isobornane, tricyclodecane and tetracyclododecane from which one or more hydrogen atoms are removed. Particularly preferable is the group of adamantane from which one or more hydrogen atoms are removed (that may further have a substituent).

When the alicyclic group of the above Y^{b} has a substituent on the ring skeleton, the substituent is exemplified by polar groups such as a hydroxyl group, carboxyl group, cyano group and oxygen atom (=O), and linear or branched alkyl groups having 1 or more and 4 or less carbon atoms. The polar group is preferably an oxygen atom (=O) in particular.

When Y^{b} is an alkyl group, it is preferably a linear or branched alkyl group having 1 or more and 20 or less carbon atoms, and more preferably 6 or more and 15 or less carbon atoms. The alkyl group is an alkoxyalkyl group particularly preferable. Examples of such an alkoxyalkyl group include a 1-methoxyethyl group, 1-ethoxyethyl group, 1-n-propoxyethyl group, 1-isopropoxyethyl group, 1-n-butoxyethyl group, 1-isobutoxyethyl group, 1-tert-butoxyethyl group, 1-methoxypropyl group, 1-ethoxypropyl group, 1-methoxy-1-methylethyl group, 1-ethoxy-1-methylethyl group, and the like.

Preferable specific examples of the constituent unit represented by the above formula (b5) include constituent units represented by the following formulae (b5-1) to (b5-33).

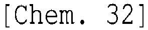

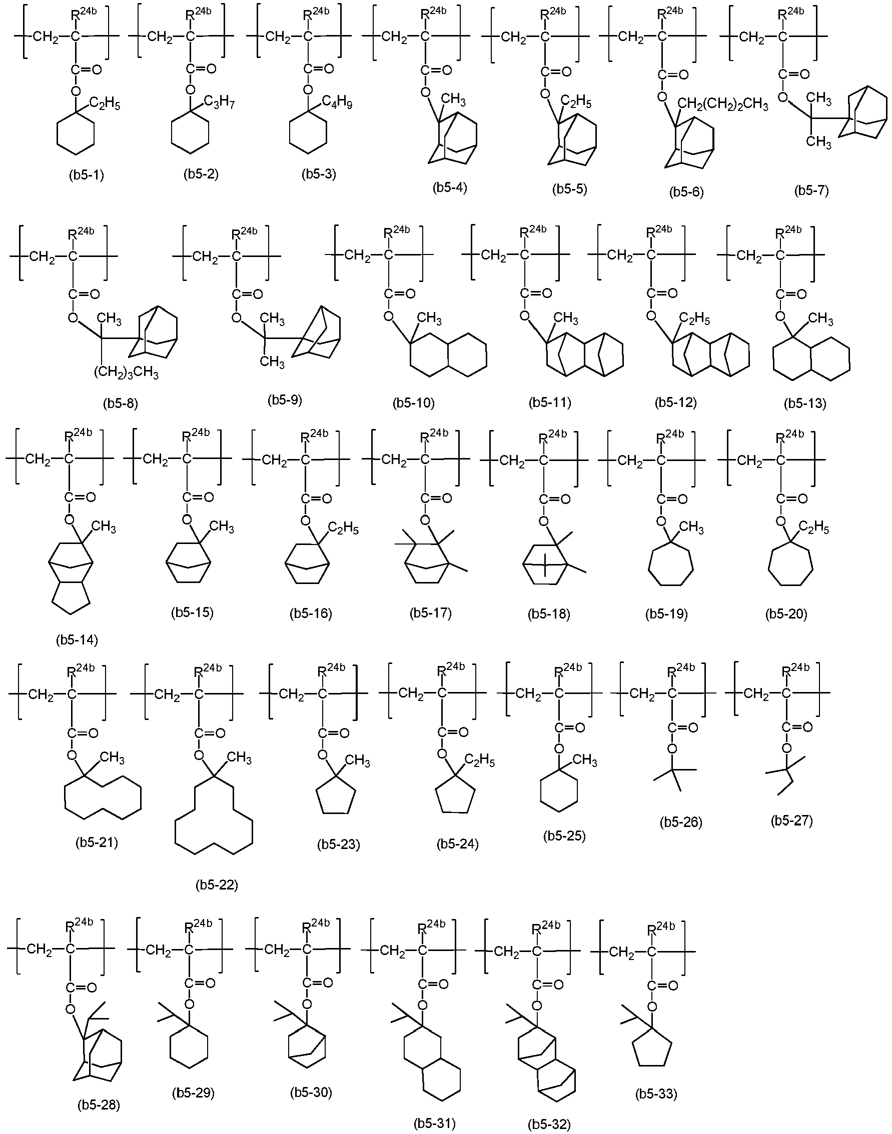

In the above formulae (b5-1) to (b5-33), R^{24b} represents a hydrogen atom or a methyl group.

Preferable specific examples of the constituent unit represented by the above formula (b6) include constituent units represented by the following formulae (b6-1) to (b6-26).

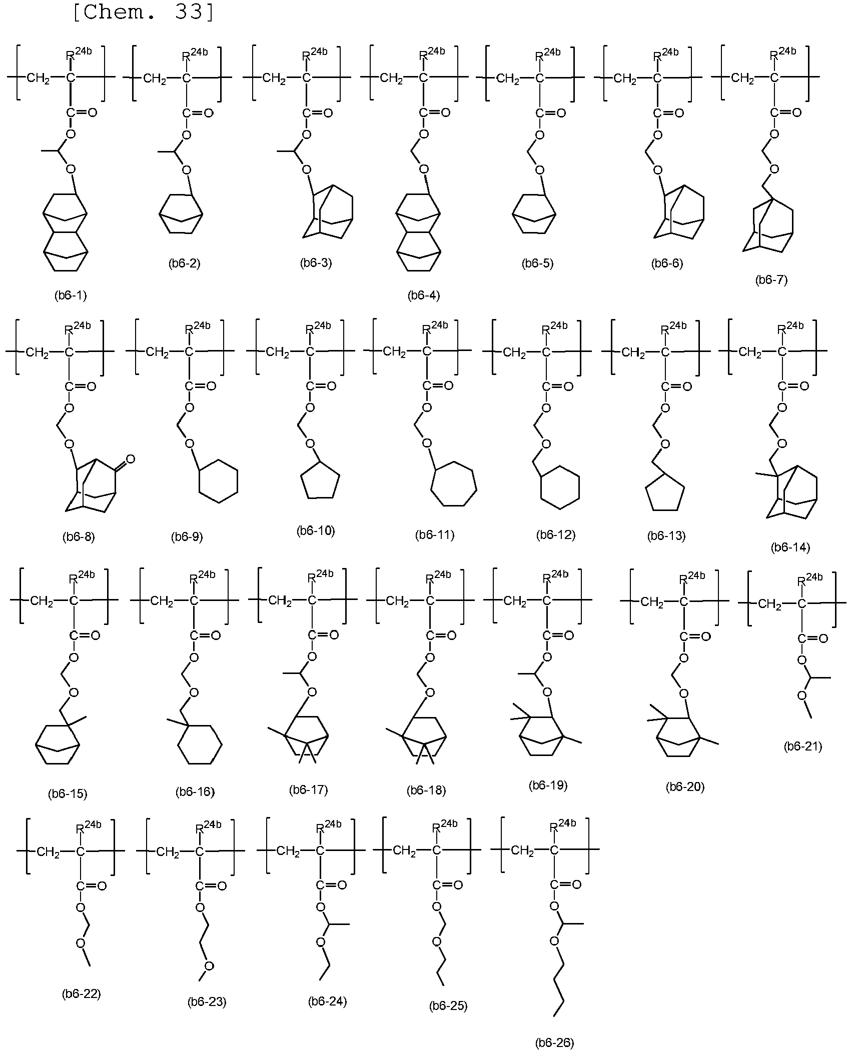

In the above formulae (b6-1) to (b6-26), R^{24b} represents a hydrogen atom or a methyl group.

Preferable specific examples of the constituent unit represented by the above formula (b7) include constituent units represented by the following formulae (b7-1) to (b7-15).

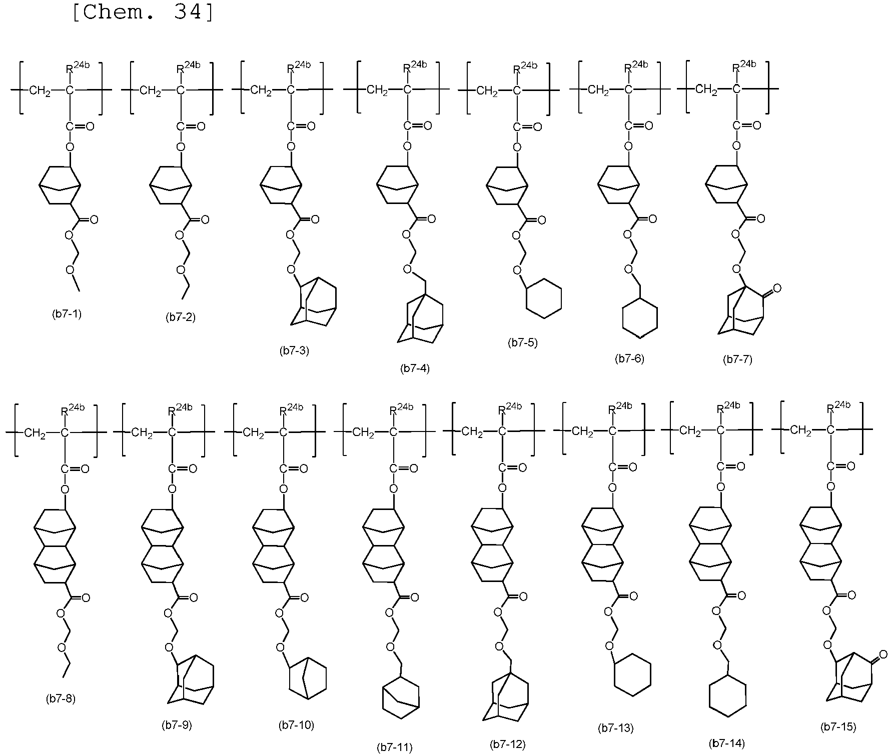

In the above formulae (b7-1) to (b7-15), R^{24b} represents a hydrogen atom or a methyl group.

Among the constituent units represented by the formulae (b5) to (b7) described above, those represented by the formula (b6) are preferred in that they can be easily synthesized and relatively easily sensitized. Further, among the constituent units represented by the formula (b6), those in which Y^{b} is an alkyl group are preferred, and those in which one or both of R^{19b} and R^{20b} are alkyl groups are preferred.

Further, the acrylic resin (B3) is preferably a resin including a copolymer including a constituent unit derived from a polymerizable compound having an ether bond together with a constituent unit represented by the above formulae (b5) to (b7).

Illustrative examples of the polymerizable compound having an ether bond include radical polymerizable compounds such as (meth)acrylic acid derivatives having an ether bond and an ester bond, and specific examples thereof include 2-methoxyethyl (meth)acrylate, 2-ethoxyethyl (meth)acrylate, methoxytriethylene glycol (meth)acrylate, 3-methoxybutyl (meth)acrylate, ethylcarbitol (meth)acrylate, phenoxypolyethylene glycol (meth)acrylate, methoxypolyethylene glycol (meth)acrylate, methoxypolypropylene glycol (meth)acrylate, tetrahydrofurfuryl (meth)acrylate, and the like. Also, the above polymerizable compound having an ether bond is preferably, 2-methoxyethyl (meth)acrylate, 2-ethoxyethyl (meth)acrylate, or methoxytriethylene glycol (meth)acrylate. These polymerizable compounds may be used alone, or in combinations of two or more thereof.

Furthermore, the acrylic resin (B3) may include another polymerizable compound as a constituent unit in order to moderately control physical or chemical properties. The polymerizable compound is exemplified by conventional radical polymerizable compounds and anion polymerizable compounds.

Examples of the polymerizable compound include monocarboxylic acids such as acrylic acid, methacrylic acid and crotonic acid; dicarboxylic acids such as maleic acid, fumaric acid and itaconic acid; methacrylic acid derivatives having a carboxyl group and an ester bond such as 2-methacryloyloxyethyl succinic acid, 2-methacryloyloxyethyl maleic acid, 2-methacryloyloxyethyl phthalic acid, and 2-methacryloyloxyethyl hexahydrophthalic acid; (meth)acrylic acid alkyl esters such as methyl(meth)acrylate, ethyl(meth)acrylate, butyl(meth)acrylate and cyclohexyl(meth)acrylate; (meth)acrylic acid hydroxyalkyl esters such as 2-hydroxyethyl (meth)acrylate and 2-hydroxypropyl (meth)acrylate; (meth)acrylic acid aryl esters such as phenyl (meth)acrylate and benzyl (meth)acrylate; dicarboxylic acid diesters such as diethyl maleate and dibutyl fumarate; vinyl group-containing aromatic compounds such as styrene, α-methylstyrene, chlorostyrene, chloromethylstyrene, vinyltoluene, hydroxystyrene, α-methylhydroxystyrene and α-ethylhydroxystyrene; vinyl group-containing aliphatic compounds such as vinyl acetate; conjugated diolefins such as butadiene and isoprene; nitrile group-containing polymerizable compounds such as acrylonitrile and methacrylonitrile; chlorine-containing polymerizable compounds such as vinyl chloride and vinylidene chloride; amide bond-containing polymerizable compounds such as acrylamide and methacrylamide; and the like.

As described above, the acrylic resin (B3) may include a constituent unit derived from a polymerizable compound having a carboxy group such as the above monocarboxylic acids and dicarboxylic acids. However, it is preferable that the acrylic resin (B3) does not substantially include a constituent unit derived from a polymerizable compound having a carboxyl group, since a resist pattern including a nonresist portion having a more favorable rectangular sectional shape can easily be formed. Specifically, the proportion of a constituent unit derived from a polymerizable compound having a carboxyl group in the acrylic resin (B3) is preferably 20% by mass or less, more preferably 15% by mass or less, and particularly preferably 5% by mass or less. In acrylic resin (B3), acrylic resin including a relatively large amount of constituent unit derived from a polymerizable compound having a carboxy group is preferably used in combination with an acrylic resin that includes only a small amount of constituent unit derived from a polymerizable compound having a carboxy group or does not include this constituent unit.

Furthermore, examples of the polymerizable compound include (meth)acrylic acid esters having a non-acid-dissociable aliphatic polycyclic group, and vinyl group-containing aromatic compounds and the like. As the non-acid-dissociable aliphatic polycyclic group, particularly, a tricyclodecanyl group, an adamantyl group, a tetracyclododecanyl group, an isobornyl group, a norbornyl group, and the like are preferred in view of easy industrial availability and the like. These aliphatic polycyclic groups may have a linear or branched alkyl group having 1 or more and 5 or less carbon atoms as a substituent.

Specific examples of the constituent units derived from the (meth)acrylic acid esters having a non-acid-dissociable aliphatic polycyclic group include constituent units having structures represented by the following formulae (b8-1) to (b8-5).

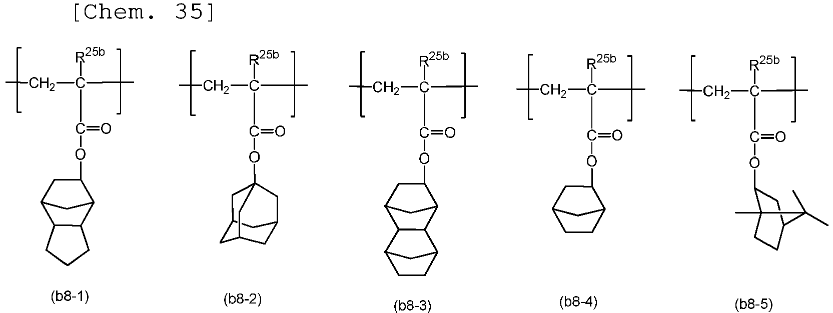

In the formulae (b8-1) to (b8-5), R^{25b} represents a hydrogen atom or a methyl group.

When the acrylic resin (B3) includes the constituent unit (b-3) including a -SO₂-containing cyclic group or a lactone-containing cyclic group, the content of the constituent unit (b-3) in the acrylic resin (B3) is preferably 5% by mass or more, more preferably 10% by mass or more, and particularly preferably 10 % by mass or more and 50% by mass or less, and most preferably 10 % by mass or more and 30% by mass or less. In a case where the chemically amplified positive-type photosensitive composition includes the constituent unit (b-3) having the above-mentioned range of amount, both good developing property and a good pattern shape can be easily achieved simultaneously.

Further, in the acrylic resin (B3), a constituent unit represented by the aforementioned formulae (b5) to (b7) is preferably included in an amount of 5% by mass or more, more preferably 10% by mass or more, and particularly preferably 10% by mass or more and 50% by mass or less.

The acrylic resin (B3) preferably includes the above constituent unit derived from a polymerizable compound having an ether bond. The content of the constituent unit derived from a polymerizable compound having an ether bond in the acrylic resin (B3) is preferably 0% by mass or more and 50% by mass or less, and more preferably 5% by mass or more and 30% by mass or less.

The acrylic resin (B3) preferably includes the above constituent unit derived from (meth)acrylic acid esters having a non-acid-dissociable aliphatic polycyclic group. The content of the constituent unit derived from (meth)acrylic acid esters having a non-acid-dissociable aliphatic polycyclic group in the acrylic resin (B3) is preferably 0% by mass or more and 50% by mass or less, and more preferably 5% by mass or more and 30% by mass or less.

As long as the chemically amplified positive-type photosensitive composition contains a predetermined amount of the acrylic resin (B3), an acrylic resin other than the acrylic resin (B3) described above can also be used as the resin (B). There is no particular limitation for such an acrylic resin other than the acrylic resin (B3) as long as it includes a constituent unit represented by the aforementioned formulae (b5) to (b7).

The mass-average molecular weight of the resin (B) described above in terms of polystyrene is preferably 10000 or more and 600000 or less, more preferably 20000 or more and 400000 or less, and even more preferably 30000 or more and 300000 or less. A mass-average molecular weight within these ranges allows a photosensitive composition film to maintain sufficient strength without reducing detachability from a substrate, and can further prevent a swelled profile and crack generation when plating.

It is also preferred that the resin (B) has a dispersivity of 1.05 or more. Dispersivity herein indicates a value of a mass average molecular weight divided by a number average molecular weight. A dispersivity in the range described above can avoid problems with respect to stress resistance on intended plating or possible swelling of metal layers resulting from the plating process.

The content of the resin (B) is preferably 5% by mass or more and 60% by mass or less with respect to the total mass of the chemically amplified positive-type photosensitive composition. Furthermore, the content of the resin (B) is preferably 5% by mass or more and 98% by mass or less, and more preferably 10% by mass or more and 95% by mass or less with respect to the total solid mass of the positive-type photosensitive composition.

### [Sulfur-containing compound and/or nitrogen-containing compound (C)]

The chemically amplified positive-type photosensitive composition includes a sulfur-containing compound and/or a nitrogen-containing compound (C) each having a predetermined structure. Therefore, when the chemically amplified positive-type photosensitive composition containing the sulfur-containing compound and/or the nitrogen-containing compound (C) each having a predetermined structure is used, a resist pattern having a desired shape and dimension is easily formed even if a metal substrate made of, for example, Cu, which tends to cause a cross-sectional shape defect such as footing upon formation of the resist pattern, is used. The sulfur-containing compound and the nitrogen-containing compound will now be described.

### (Sulfur-containing compound)

The sulfur-containing compound is a compound including a sulfur atom to be coordinated with metal constituting the metal layer. Note here that in a compound that can generate two or more tautomers, when at least one tautomer includes a sulfur atom to be coordinated with metal constituting the metal layer, the compound corresponds to the sulfur-containing compound. Furthermore, a compound corresponding to both the sulfur-containing compound and the below-mentioned nitrogen-containing compound will be described herein as the sulfur-containing compound.

The sulfur atom that can coordinate with metal constituting the metal layer is included in a sulfur-containing compound as, for example, a mercapto group (-SH), a thiocarboxy group (-CO-SH), a dithiocarboxy group (-CS-SH), a thiocarbonyl group (-CS-), and the like. From the viewpoint of easiness in coordinating with metal constituting the metal layer and being excellent in suppressing footing, the sulfur-containing compound preferably includes a mercapto group.

Preferable examples of the sulfur-containing compound having a mercapto group include compounds represented by the following formula (c1). 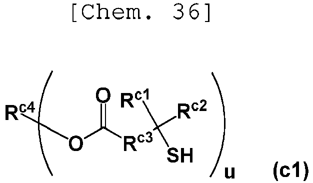 (In the formula, R^{c1} and R^{c2} each independently represent a hydrogen atom or an alkyl group, R^{c3} represents a single bond or an alkylene group, R^{c4} represents a u-valence aliphatic group which may include an atom other than carbon, and u is an integer of 2 or more and 4 or less.)

R^{c1} and R^{c2} are an alkyl group, the alkyl group may be linear or branched, and is preferably linear. When R^{c1} and R^{c2} are an alkyl group, the number of carbon atoms of the alkyl group is not particularly limited within a range where the objects of the present invention are not impaired. The number of carbon atoms of the alkyl group is preferably 1 or more and 4 or less, particularly preferably 1 or 2, and the most preferably 1. As the combination of R^{c1} and R^{c2}, preferably, one is a hydrogen atom and the other is an alkyl group, and particularly preferably one is a hydrogen atom and the other is a methyl group.

When R^{c3} is an alkylene group, the alkylene group may be linear or branched, and is preferably linear. When R^{c3} is an alkylene group, the number of carbon atoms of the alkylene group is not particularly limited within a range where the objects of the present invention are not impaired. The number of carbon atoms of the alkylene group is preferably 1 or more and 10 or less, more preferably 1 or more and 5 or less, particularly preferably 1 or 2, and the most preferably 1.

R^{c4} is an aliphatic group having two or more and four or less valences and which may include an atom other than carbon atom. Examples of the atoms which may be included in R^{c4} include a nitrogen atom, an oxygen atom, a sulfur atom, a fluorine atom, a chlorine atom, a bromine atom, an iodine atom, and the like. A structure of the aliphatic group as R^{c4} may be linear or branched, or may be cyclic, and a structure combining these structures.

Among the compounds represented by the formula (c1), a compound represented by the following formula (c2) is more preferable. 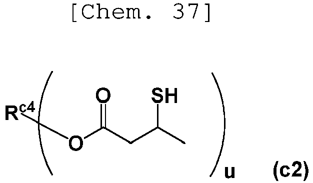 (In the formula (c2), R^{c4} and u are the same as those in the formula (c1).)

Among the compounds represented by the above formula (c2), the following compounds are preferable.

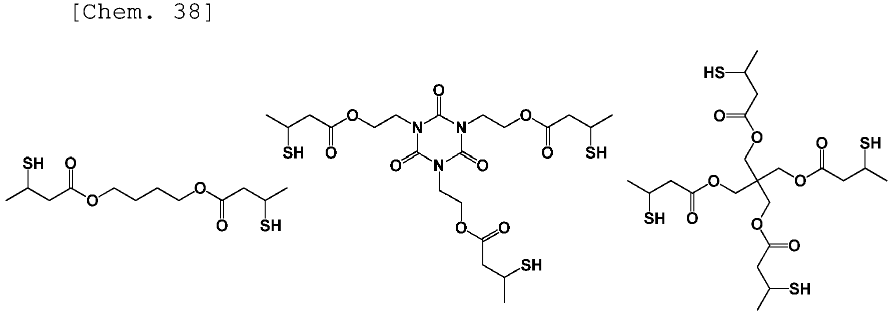

Compounds represented by the following formulae (c3-L1) to (c3-L7) are also preferable examples as the sulfur-containing compound having a mercapto group. 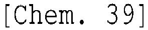 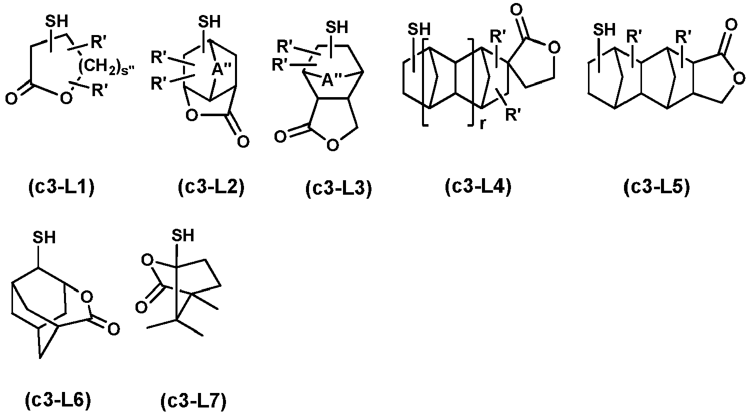 (In the formulae (c3-L1) to (c3-L7), R', s", A", and r are the same as in the formulae (b-L1) to (b-L7) described for the acrylic resin (B3).)

Suitable specific examples of the mercapto compound represented by the above formulae (c3-L1) to (c3-L7) include the following compounds.

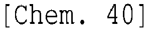

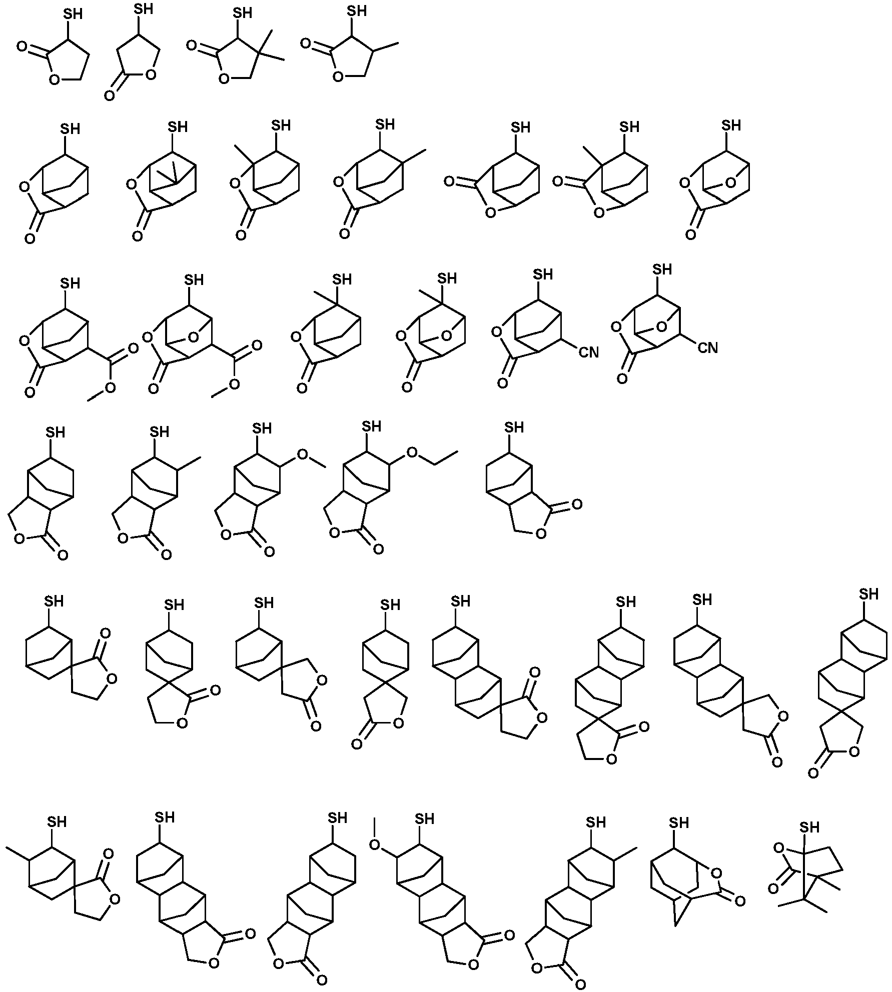

Compounds represented by the following formulae (c3-1) to (c3-4) are also preferable examples as the sulfur-containing compound having a mercapto group. 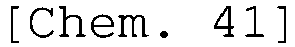 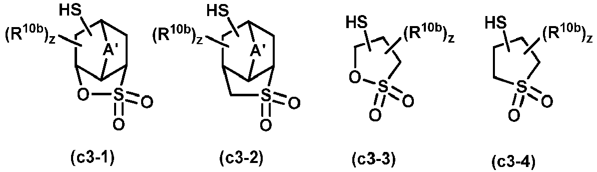 (In the formulae (c3-1) to (c3-4), definitions of abbreviations are the same as mentioned for the formulae (3-1) to (3-4) described for acrylic resin (B3).)

Suitable specific examples of the mercapto compound represented by the above formulae (c3-1) to (c3-4) include the following compounds.

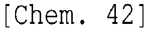

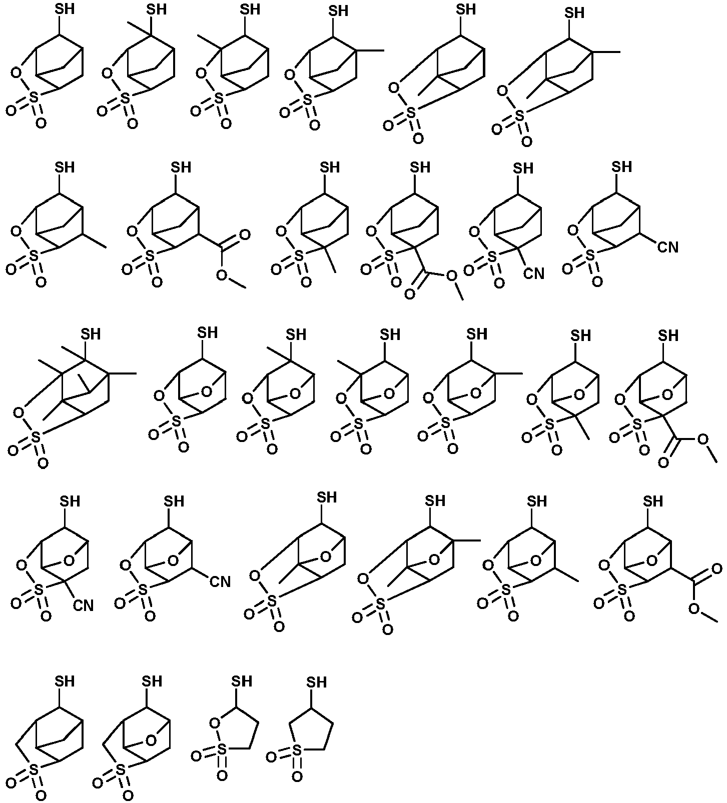

Furthermore, preferable examples of the compound having a mercapto group include compounds represented by the following formula (c4). 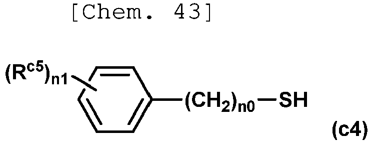 (In the formula (c4), R^{c5} is a group selected from the group consisting of a hydroxyl group, an alkyl group having 1 or more 4 or less carbon atoms, an alkoxy group having 1 or more 4 or less carbon atoms, an alkylthio group having 1 or more and 4 or less carbon atoms, a hydroxyalkyl group having 1 or more and 4 or less carbon atoms, a mercapto alkyl group having 1 or more and 4 or less carbon atoms, a halogenated alkyl group having 1 or more and 4 or less carbon atoms, and a halogen atom, n1 is an integer of 0 or more and 3 or less, n0 is an integer of 0 or more and 3 or less, when n1 is 2 or 3, R^{c5} may be the same as or different from each other.)

Specific examples when R^{c5} is an alkyl group which may have a hydroxyl group having 1 or more 4 or less carbon atoms include a methyl group, an ethyl group, an n-propyl group, an isopropyl group, an n-butyl group, an isobutyl group, a sec-butyl group, and a tert-butyl group. Among these alkyl groups, a methyl group, a hydroxymethyl group, and an ethyl group are preferable.

Specific examples when R^{c5} is an alkoxy group having 1 or more 4 or less carbon atoms include a methoxy group, an ethoxy group, an n-propyloxy group, an isopropyloxy group, an n-butyloxy group, an isobutyloxy group, a sec-butyloxy group, and a tert-butyloxy group. Among these alkoxy groups, a methoxy group and an ethoxy group are preferable, and a methoxy group is more preferable.

Specific examples when R^{c5} is an alkylthio group having 1 or more 4 or less carbon atoms include a methylthio group, an ethylthio group, an n-propylthio group, an isopropylthio group, an n-butylthio group, an isobutylthio, a sec-butylthio group, and a tert-butylthio group. Among these alkylthio groups, a methylthio group, and an ethylthio group are preferable, and a methylthio group is more preferable.

Specific examples when R^{c5} is a hydroxyalkyl group having 1 or more 4 or less carbon atoms include a hydroxymethyl group, a 2-hydroxyethyl group, a 1-hydroxyethyl group, a 3-hydroxy-n-propyl group, and a 4-hydroxy-n-butyl group, and the like. Among these hydroxyalkyl groups, a hydroxymethyl group, a 2-hydroxyethyl group, and a 1-hydroxyethyl group are preferable, and a hydroxymethyl group is more preferable.

Specific examples when R^{c5} is a mercapto alkyl group having 1 or more 4 or less carbon atoms include a mercapto methyl group, a 2-mercapto ethyl group, a 1-mercapto ethyl group, a 3-mercapto-n-propyl group, a 4-mercapto-n-butyl group, and the like. Among these mercapto alkyl groups, a mercapto methyl group, a 2-mercapto ethyl group, and 1-mercapto ethyl group are preferable, and a mercapto methyl group is more preferable.

When R^{c5} is an alkyl halide group having 1 or more 4 or less carbon atoms, examples of the halogen atom included in the alkyl halide group include fluorine, chlorine, bromine, iodine, and the like. Specific examples when R^{c5} is an alkyl halide group having 1 or more 4 or less carbon atoms include a chloromethyl group, a bromomethyl group, an iodomethyl group, a fluoromethyl group, a dichloromethyl group, a dibromomethyl group, a difluoromethyl group, a trichloromethyl group, a tribromomethyl group, a trifluoromethyl group, a 2-chloroethyl group, a 2-bromoethyl group, a 2-fluoroethyl group, a 1,2-dichloroethyl group, a 2,2-difluoroethyl group, a 1-chloro-2-fluoroethyl group, 3-chloro-n-propyl group, a 3-bromon-propyl group, a 3-fluoro-n-propyl group, 4-chloro-n-butyl group, and the like. Among these alkyl halide groups, a chloromethyl group, a bromomethyl group, an iodomethyl group, a fluoromethyl group, a dichloromethyl group, a dibromomethyl group, a difluoromethyl group, a trichloromethyl group, a tribromomethyl group, and a trifluoromethyl group are preferable, and a chloromethyl group, a dichloromethyl group, a trichloromethyl group, and a trifluoromethyl group are more preferable.

Specific examples when R^{c5} is a halogen atom include fluorine, chlorine, bromine, or iodine.

In the formula (c4), n1 is an integer of 0 or more 3 or less, and 1 is more preferable. When n1 is 2 or 3, a plurality of R^{c5} may be the same as or different from each other.

In the compound represented by the formula (c4), a substituted position of R^{c5} on a benzene ring is not particularly limited. The substituted position of R^{c5} on a benzene ring is preferably a meta position or a para position with respect to the bond position of -(CH₂)ₙ₀-SH.

The compound represented by the formula (c4) is preferably a compound having at least one group selected from the group consisting of an alkyl group, a hydroxyalkyl group, and a mercapto alkyl group as R^{c5}, and more preferably a compound having one group selected from the group consisting of an alkyl group, a hydroxyalkyl group, and a mercapto alkyl group as R^{c5}. When the compound represented by the formula (c4) has one group selected from the group consisting of an alkyl group, a hydroxyalkyl group, and a mercapto alkyl group as R^{c5}, the substituted position on the benzene ring of the alkyl group, the hydroxyalkyl group, or the mercapto alkyl group is preferably a meta position or a para position with respect to the bond position of -(CH₂)ₙ₀-SH, and more preferably a para position.

In the formula (c4), n0 is an integer of 0 or more 3 or less. From the viewpoint that preparation or availability of a compound is easy, n0 is preferably 0 or 1, and more preferably 0.

Specific examples of the compound represented by the formula (c4) include p-mercaptophenol, p-thiocresol, m-thiocresol, 4-(methylthio)benzenethiol, 4-methoxybenzenethiol, 3-methoxybenzenethiol, 4-ethoxybenzenethiol, 4-isopropyloxy benzenethiol, 4-tert-butoxybenzenethiol, 3,4-dimethoxy benzenethiol, 3,4,5-trimethoxybenzenethiol, 4-ethylbenzenethiol, 4-isopropyl benzenethiol, 4-n-butylbenzenethiol, 4-tert-butylbenzenethiol, 3-ethylbenzenethiol, 3-isopropyl benzenethiol, 3-n-butylbenzenethiol, 3-tert-butylbenzenethiol, 3,5-dimethyl benzenethiol, 3,4-dimethyl benzenethiol, 3-tert-butyl-4-methylbenzenethiol, 3-tert-4-methylbenzenethiol, 3-tert-butyl-5-methylbenzenethiol, 4-tert-butyl-3-methylbenzenethiol, 4-mercaptobenzyl alcohol, 3-mercaptobenzyl alcohol, 4-(mercaptomethyl)phenol, 3-(mercaptomethyl)phenol, 1,4-di(mercaptomethyl)phenol, 1,3-di(mercaptomethyl)phenol, 4-fluorobenzenethiol, 3-fluorobenzenethiol, 4-chlorobenzenethiol, 3-chlorobenzenethiol, 4-bromobenzenethiol, 4-iodobenzenethiol, 3-bromobenzenethiol, 3,4-dichlorobenzenethiol, 3,5-dichlorobenzenethiol, 3,4-difluorobenzenethiol, 3,5-difluorobenzenethiol, 4-mercaptocatechol, 2,6-di-tert-butyl-4-mercaptophenol, 3,5-di-tert-butyl-4-methoxybenzenethiol, 4-bromo-3-methylbenzenethiol, 4-(trifluoromethyl)benzenethiol, 3-(trifluoromethyl)benzenethiol, 3,5-bis(trifluoromethyl)benzenethiol, 4-methylthiobenzenethiol, 4-ethylthiobenzenethiol, 4-n-butylthiobenzenethiol, and 4-tert-butylthiobenzenethiol, and the like.

Furthermore, examples of the sulfur-containing compound having a mercapto group include a compound including nitrogen-containing aromatic heterocycle substituted with a mercapto group, and a tautomer of a compound including nitrogen-containing aromatic heterocycle substituted with a mercapto group. Preferable specific examples of the nitrogen-containing aromatic heterocycle include imidazole, pyrazole, 1,2,3-triazol, 1,2,4-triazol, oxazole, thiazole, pyridine, pyrimidine, pyridazine, pyrazine, 1,2,3-triazine, 1,2,4-triazine, 1,3,5-triazine, indole, indazole, benzimidazole, benzoxazole, benzothiazole, 1H-benzotriazole, quinoline, isoquinoline, cinnoline, phthalazine, quinazoline, quinoxaline, and 1,8-naphthyridine.

Suitable specific examples of a nitrogen-containing heterocyclic compound suitable as a sulfur-containing compound, and suitable tautomer of the nitrogen-containing heterocyclic compound include the following compounds.

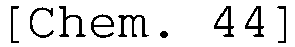

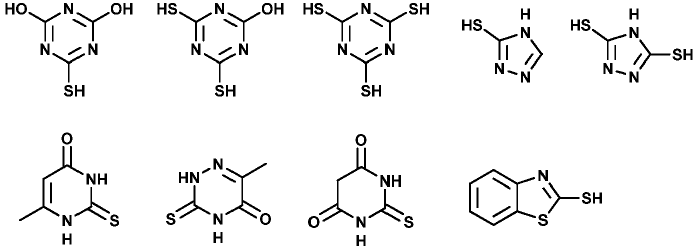

### (Nitrogen-containing compound)

The nitrogen-containing compound is a compound including a nitrogen atom constituting a nitrogen-containing aromatic heterocycle to be coordinated with metal constituting the metal layer on the substrate. In other words, the nitrogen-containing compound is coordinated with metal constituting the metal layer on the substrate via the nitrogen-containing heterocycle included in its structure. Note here that, as mentioned above, a compound corresponding to both the sulfur-containing compound and the nitrogen-containing compound will be described herein as the sulfur-containing compound.

Examples of the nitrogen-containing aromatic heterocyclic compound that can be used as nitrogen-containing compound include pyrrole compounds, pyrazole compounds, imidazole compounds, triazole compounds, tetrazole compounds, pyridine compounds, pyrazine compounds, pyridazine compounds, pyrindine compounds, indolizine compounds, indole compounds, isoindole compounds, indazole compounds, purine compounds, quinolizine compounds, quinoline compounds, isoquinoline compounds, naphthyridine compounds, phthalazine compounds, quinoxaline compounds, quinazoline compounds, cinnoline compounds, buterizine compounds, thiazole compounds, isothiazole compounds, oxazole compounds, isoxazole compounds, furazan compounds and the like.

Examples of the pyrazole compounds include 4-nitro-3-pyrazole carboxylic acid, pyrazole-3,5-dicarboxylic acid. 3-amino-5-phenylpyrazole, 5-amino-3-phenylpyrazole, 3,4,5-tribromopyrazole, 3-aminopyrazole, 3,5-dimethylpyrazole, 3,5-dimethyl-1-hydroxymethylpyrazole, 3-methylpyrazole, 1-methylpyrazole, 3-amino-5-methylpyrazole, 4-amino-pyrazolo[3,4-D]pyrimidine, allopurinol, 4-chloro-1H-pyrazolo[3,4-D]pyrimidine, 3,4-dihydroxy-6-methylpyrazolo(3,4-B)-pyridine, 6-methyl-1H-pyrazolo[3,4-B]pyridine-3-amine and the like.

Examples of the imidazole compounds include imidazole, 1-methylimidazole, 2-methylimidazole, 4-methylimidazole, 1,2-dimethylimidazole, 2-ethyl-4-methylimidazole, 2-isopropylimidazole, benzoimidazole, 5,6-dimethylbenzoimidazole, 2-aminobenzoimidazole, 2-chlorobenzoimidazole, 2-methylbenzoimidazole, 2-(1-hydroxyethyl)benzoimidazole, 2-hydroxybenzoimidazole, 2-phenylbenzoimidazole, 2,5-dimethylbenzoimidazole, 5-methylbenzoimidazole, 5-nitrobenzoimidazole, 1H-purine and the like.

Examples of the triazole compounds include 1,2,3-triazole, 1,2,4-triazole, 1-methyl-1,2,4-triazole, methyl 1H-1,2,4-triazole-3-carboxylate, 1,2,4-triazole-3-carboxylic acid, methyl 1,2,4-triazole-3-carboxylate, 1H-1,2,4-triazole-3-thiol, 3,5-diamino-1H-1,2,4-triazole, 3-amino-1,2,4-triazole-5- thiol, 3-amino-1H-1,2,4-triazole, 3-amino-5-benzyl-4H-1,2,4-triazole, 3-amino-5-methyl-4H-1,2,4-triazole, 3-nitro-1,2,4-triazole, 3-bromo-5-nitro-1,2,4-triazole, 4-(1,2,4-triazole-1-yl)phenol, 4-amino-1,2,4-triazole, 4-amino-3,5-dipropyl-4H-1,2,4-triazole, 4-amino-3,5-dimethyl-4H-1,2,4-triazole, 4-amino-3,5-diheptyl-4H-1,2,4-triazole, 5-methyl-1,2,4-triazole-3,4-diamine, 1H-benzotriazole, 1-hydroxybenzotriazole, 1-aminobenzotriazole, 1-carboxybenzotriazole, 5-chloro-1H-benzotriazole, 5-nitro-1H-benzotriazole, 5-carboxy-1H-benzotriazole, 5-methyl-1H-benzotriazole, 5,6-dimethyl-1H-benzotriazole, 1-(1',2'-dicarboxyethyl)benzotriazole, 1-[N,N-bis(hydroxyethyl)aminomethyl]benzotriazole, 1-[N,N-bis(hydroxyethyl)aminomethyl]-5-methylbenzotriazole, 1-[N,N-bis(hydroxyethyl)aminomethyl]-4-methylbenzotriazole and the like.

Example of tetrazole compounds include 1H-tetrazole, 5-methyltetrazole, 5-aminotetrazole, 5-phenyltetrazole and the like.

Examples of indazole compounds include 1H-indazole, 5-amino-1H-indazole, 5-nitro-1H-indazole, 5-hydroxy-1H-indazole, 6-amino-1H-indazole, 6-nitro-1H-indazole, 6-hydroxy-1H-indazole, 3-carboxy-5-methyl-1H-indazole and the like

Examples of indole compounds include 1H-indole, 1-methyl-1H-indole, 2-methyl-1H-indole, 3-methyl-1H-indole, 4-methyl-1H-indole, 5-methyl-1H-indole, 6-methyl-1H-indole, 7-methyl-1H-indole, 4-amino-1H-indole, 5-amino-1H-indole, 6-amino-1H-indole, 7-amino-1H-indole, 4-hydroxy-1H-indole, 5-hydroxy-1H-indole, 6-hydroxy-1H-indole, 7-hydroxy-1H-indole, 4-methoxy-1H-indole, 5-methoxy-1H-indole, 6-methoxy-1H-indole, 7-methoxy-1H-indole, 4-chloro-1H-indole, 5-chloro-1H-indole, 6-chloro-1H-indole, 7-chloro-1H-indole, 4-carboxy-1H-indole, 5-carboxy-1H-indole, 6-carboxy-1H-indole, 7-carboxy-1H-indole, 4-nitro-1H-indole, 5-nitro-1H-indole, 6-nitro-1H-indole, 7-nitro-1H-indole, 4-nitrile-1H-indole, 5-nitrile-1H-indole, 6-nitrile-1H-indole, 7-nitrile-1H-indole, 2,5-dimethyl-1H-indole, 1,2-dimethyl-1H-indole, 1,3-dimethyl-1H-indole, 2,3-dimethyl-1H-indole, 5-amino-2,3-dimethyl-1H-indole, 7-ethyl-1H-indole, 5-(aminomethyl)indole, 2-methyl-5-amino-1H-indole, 3-hydroxymethyl-1H-indole, 6-isopropyl-1H-indole, 5-chloro-2-methyl-1H-indole and the like.

Among nitrogen-containing compounds described above, triazole compounds are preferred. Among triazole compound, in particular, 1H-benzotrizole, 5-methyl-1H-benzotriazole, 5,6-dimethyl-1H-benzotriazole, 1-[N,N-bis(hydroxyethyl)aminomethyl]-5-methylbenzotriazole, 1-[N,N-bis(hydroxyethyl)aminomethyl]-4-methylbenzotriazol, 1,2,3-triazole and 1,2,4-triazole are preferred.

The use amount of the sulfur-containing compound and/or nitrogen-containing compound is preferably 0.01 parts by mass or more 5 parts by mass or less, more preferably 0.02 parts by mass or more 3 parts by mass or less, and particularly preferably 0.05 parts by mass or more 2 parts by mass or less with respect to 100 parts by mass that is the total mass of the above resin (B) and the below-mentioned alkali-soluble resin (D).

### [Alkali-soluble resin (D)]

It is preferred that the chemically amplified positive-type photosensitive composition further contains an alkali-soluble resin (D) in order to improve crack resistance. The alkali-soluble resin as referred to herein may be determined as follows. A solution of the resin having a resin concentration of 20% by mass (solvent: propylene glycol monomethyl ether acetate) is used to form a resin film having a thickness of 1 µm on a substrate, and immersed in an aqueous 2.38% by mass TMAH (tetramethylammonium hydroxide) solution for 1 min. When the resin was dissolved in an amount of 0.01 µm or more, the resin is defined as being alkali soluble. As the alkali-soluble resin (D), at least one selected from the group consisting of novolak resin (D1), polyhydroxystyrene resin (D2), and acrylic resin (D3) are preferable.

### (Novolak resin (D1))

A novolak resin is prepared by addition condensation of, for example, aromatic compounds having a phenolic hydroxyl group (hereinafter, merely referred to as "phenols") and aldehydes in the presence of an acid catalyst.

Examples of the above phenols include phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 2,6-xylenol, 3,4-xylenol, 3,5-xylenol, 2,3,5-trimethyl phenol, 3,4,5-trimethyl phenol, p-phenylphenol, resorcinol, hydroquinone, hydroquinone monomethyl ether, pyrogallol, phloroglycinol, hydroxydiphenyl, bisphenol A, gallic acid, gallic acid ester, α-naphthol, β-naphthol, and the like. Examples of the above aldehydes include formaldehyde, furfural, benzaldehyde, nitrobenzaldehyde, acetaldehyde, and the like. The catalyst used in the addition condensation reaction is not particularly limited, and examples thereof include hydrochloric acid, nitric acid, sulfuric acid, formic acid, oxalic acid, acetic acid, etc., for acid catalyst.

The flexibility of the novolak resins can be enhanced more when o-cresol is used, a hydrogen atom of a hydroxyl group in the resins is substituted with other substituents, or bulky aldehydes are used.

The mass average molecular weight of novolac resin (D1) is not particularly limited as long as the purpose of the present invention is not impaired, but the mass average molecular weight is preferably 1,000 or more and 50,000 or less.

### (Polyhydroxystyrene resin (D2))

The hydroxystyrene compound to constitute the polyhydroxystyrene resin (D2) is exemplified by p-hydroxystyrene, α-methylhydroxystyrene, α-ethylhydroxystyrene, and the like. Furthermore, the polyhydroxystyrene resin (D2) is preferably prepared to give a copolymer with a styrene resin. Examples of the styrene compound to constitute such a styrene resin include styrene, chlorostyrene, chloromethylstyrene, vinyltoluene, α-methylstyrene, and the like.

The mass average molecular weight of the polyhydroxystyrene resin (D2) is not particularly limited as long as the purpose of the present invention is not impaired, but the mass average molecular weight is preferably 1,000 or more and 50,000 or less.

### (Acrylic resin (D3))

It is preferable that the acrylic resin (D3) includes a constituent unit derived from a polymerizable compound having an ether bond and a constituent unit derived from a polymerizable compound having a carboxyl group.

Examples of the above polymerizable compound having an ether bond include (meth)acrylic acid derivatives having an ether bond and an ester bond such as 2-methoxyethyl (meth)acrylate, methoxytriethylene glycol (meth)acrylate, 3-methoxybutyl (meth)acrylate, ethylcarbitol (meth)acrylate, phenoxypolyethylene glycol (meth)acrylate, methoxypolypropylene glycol (meth)acrylate, tetrahydrofurfuryl (meth)acrylate, and the like. The above polymerizable compound having an ether bond is preferably, 2-methoxyethyl acrylate, and methoxytriethylene glycol acrylate. These polymerizable compounds may be used alone, or in combinations of two or more.

Examples of the above polymerizable compound having a carboxy group include monocarboxylic acids such as acrylic acid, methacrylic acid and crotonic acid; dicarboxylic acids such as maleic acid, fumaric acid and itaconic acid; compounds having a carboxy group and an ester bond such as 2-methacryloyloxyethyl succinic acid, 2-methacryloyloxyethyl maleic acid, 2-methacryloyloxyethyl phthalic acid, 2-methacryloyloxyethyl hexahydrophthalic acid and the like. The above polymerizable compound having a carboxy group is preferably, acrylic acid and methacrylic acid. These polymerizable compounds may be used alone, or in combinations of two or more thereof.

The mass average molecular weight of the acrylic resin (D3) is not particularly limited as long as the purpose of the present invention is not impaired, but the mass average molecular weight is preferably 50,000 or more and 800,000 or less.

The content of the alkali-soluble resin (D) is such that when the total amount of the above resin (B) and the alkali-soluble resin (D) is taken as 100 parts by mass, the content is preferably 0 parts by mass or more and 80 parts by mass or less, and more preferably 0 parts by mass or more and 60 parts by mass or less. By setting the content of the alkali-soluble resin (D) to the range described above, there is a tendency for resistance to cracking to increase, and film loss at the time of development can be prevented.

### [Acid diffusion suppressing agent (E)]

The preferable chemically amplified positive-type photosensitive composition preferably further includes an acid diffusion suppressing agent (E) for the purpose of improving a shape of the resist pattern to be used as the template, post-exposure stability of the photosensitive composition film, and the like. The acid diffusion suppressing agent (E) is preferably a nitrogen-containing suppressing agent (E1), and an organic carboxylic acid, or an oxo acid of phosphorus or a derivative thereof (E2) may be further included as needed.

### (Nitrogen-containing suppressing agent (E1))

Examples of the nitrogen-containing suppressing agent (E1) include nitrogen atom-containing compounds which do not correspond to the nitrogen-containing compound meeting the predetermined requirements mentioned above. Note here that the above-mentioned nitrogen-containing compound serving as a component for suppressing footing may act as the acid diffusion suppressing agent (E) depending on a use amount. Examples of the nitrogen-containing suppressing agent (E1) include trimethylamine, diethylamine, triethylamine, di-n-propylamine, tri-n-propylamine, tri-n-pentylamine, tribenzylamine, diethanolamine, triethanolamine, n-hexylamine, n-heptyl amine, n-octyl amine, n-nonyl amine, ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, formamide, N-methylformamide, N,N-dimethylformamide, acetamide, N-methylacetamide, N,N-dimethylacetamide, propionamide, benzamide, pyrrolidone, N-methylpyrrolidone, methylurea, 1,1-dimethylurea, 1,3-dimethylurea, 1,1,3,3,-tetramethylurea, 1,3-diphenylurea, pyrrolidine, piperidine, morpholine, 4-methylmorpholine, 1,4-diazabicyclo[2.2.2]octane and the like. These may be used alone, or in combinations of two or more thereof.

Furthermore, commercially available hindered amine compounds such as Adeka Stab LA-52, Adeka Stab LA-57, Adeka Stab LA-63P, Adeka Stab LA-68, Adeka Stab LA-72, Adeka Stab LA-77Y, Adeka Stab LA-77G, Adeka Stab LA-81, Adeka Stab LA-82, Adeka Stab LA-87 (all manufactured by ADEKA), and the like can be used as the nitrogen-containing suppressing agent (E1).

The nitrogen-containing suppressing agent (E1) may be used in an amount typically in the range of 0 parts by mass or more and 5 parts by mass or less, and particularly preferably in the range of 0 parts by mass or more and 3 parts by mass or less, with respect to 100 parts by mass of total mass of the above resin (B) and the above alkali-soluble resin (D).

### (Organic carboxylic acid or oxo acid of phosphorus or derivative thereof (E2))

Among the organic carboxylic acid or oxo acid of phosphorus or derivative thereof (E2), specific preferred examples of the organic carboxylic acid include malonic acid, citric acid, malic acid, succinic acid, benzoic acid, salicylic acid and the like, and salicylic acid is particularly preferred.

Examples of the oxo acid of phosphorus or derivatives thereof include phosphoric acid and derivatives such as esters thereof such as phosphoric acid, phosphoric acid di-n-butyl ester, and phosphoric acid diphenyl ester; phosphonic acid and derivatives such as esters thereof such as phosphonic acid, phosphonic acid dimethyl ester, phosphonic acid di-n-butyl ester, phenylphosphonic acid, phosphonic acid diphenyl ester, and phosphonic acid dibenzyl ester; and phosphinic acid and derivatives such as esters thereof such as phosphinic acid and phenylphosphinic acid; and the like. Among these, phosphonic acid is particularly preferred. These may be used alone, or in combinations of two or more thereof.

The organic carboxylic acid or oxo acid of phosphorus or derivative thereof (E2) may be used in an amount usually in the range of 0 parts by mass or more and 5 parts by mass or less, and particularly preferably in the range of 0 parts by mass and 3 parts by mass or less, with respect to 100 parts by mass of total mass of the above resin (B) and the above alkali-soluble resin (D).

Moreover, in order to form a salt to allow for stabilization, the organic carboxylic acid, or the oxo acid of phosphorous or the derivative thereof (E2) is preferably used in an amount equivalent to that of the above nitrogen-containing compound (E1).

### [Organic solvent (S)]

The preferable chemically amplified positive-type photosensitive composition contains an organic solvent (S). There is no particular limitation on the types of the organic solvent (S) as long as the objects of the present invention are not impaired, and an organic solvent appropriately selected from those conventionally used for positive-type photosensitive compositions can be used.

Specific examples of the organic solvent (S) include ketones such as acetone, methyl ethyl ketone, cyclohexanone, methyl isoamyl ketone, and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, and a monomethyl ether, a monoethyl ether, a monopropyl ether, a monobutyl ether, and a monophenyl ether of dipropylene glycol monoacetate; cyclic ethers such as dioxane; esters such as ethyl formate, methyl lactate, ethyl lactate, methyl acetate, ethyl acetate, butyl acetate, methyl pyruvate, methyl acetoacetate, ethyl acetoacetate, ethyl pyruvate, ethylethoxy acetate, methyl methoxypropionate, ethyl ethoxypropionate, methyl 2-hydroxypropionate, ethyl 2-hydroxypropionate, ethyl 2-hydroxy-2-methylpropionate, methyl 2-hydroxy-3-methylbutanate, 3-methoxybutyl acetate, and 3-methyl-3-methoxybutyl acetate; aromatic hydrocarbons such as toluene and xylene; and the like. These may be used alone, or as a mixture of two or more thereof.

There is no particular limitation on the content of the organic solvent (S) as long as the objects of the present invention are not impaired. In a case where a chemically amplified positive-type photosensitive composition is used for a thick-film application such that a photosensitive composition film formed from the chemically amplified positive-type photosensitive composition by the spin coating method and the like and has a film thickness of 10 µm or more, the organic solvent (S) is preferably used in a range where the solid content concentration of the chemically amplified positive-type photosensitive composition is 30% by mass or more and 55% by mass or less.

### [Other components]

The photosensitive composition may further contain a polyvinyl resin for improving plasticity. Specific examples of the polyvinyl resin include polyvinyl chloride, polystyrene, polyhydroxystyrene, polyvinyl acetate, polyvinylbenzoic acid, polyvinyl methyl ether, polyvinyl ethyl ether, polyvinyl alcohol, polyvinyl pyrrolidone, polyvinyl phenol, and copolymers thereof, and the like. The polyvinyl resin is preferably polyvinyl methyl ether in view of lower glass transition temperatures.

Further, the chemically amplified positive-type photosensitive composition may also contain an adhesive auxiliary agent in order to improve the adhesiveness between a template formed with the chemically amplified positive-type photosensitive composition and a metal substrate.

Also, the chemically amplified positive-type photosensitive composition may further contain a surfactant for improving coating characteristics, defoaming characteristics, leveling characteristics, and the like. As the surfactant, for example, a fluorine-based surfactant or a silicone-based surfactant is preferably used. Specific examples of the fluorine-based surfactant include commercially available fluorine-based surfactants such as BM-1000 and BM-1100 (both manufactured by B.M-Chemie Co., Ltd.), Megafac F142D, Megafac F172, Megafac F173 and Megafac F183 (all manufactured by Dainippon Ink And Chemicals, Incorporated), Flolade FC-135, Flolade FC-170C, Flolade FC-430 and Flolade FC-431 (all manufactured by Sumitomo 3M Ltd.), Surflon S-112, Surflon S-113, Surflon S-131, Surflon S-141 and Surflon S-145 (all manufactured by Asahi Glass Co., Ltd.), SH-28PA, SH-190, SH-193, SZ-6032 and SF-8428 (all manufactured by Toray Silicone Co., Ltd.) and the like, but not limited thereto. As the silicone-based surfactant, an unmodified silicone-based surfactant, a polyether modified silicone-based surfactant, a polyester modified silicone-based surfactant, an alkyl modified silicone-based surfactant, an aralkyl modified silicone-based surfactant, a reactive silicone-based surfactant, and the like, can be preferably used. As the silicone-based surfactant, commercially available silicone-based surfactant can be used. Specific examples of the commercially available silicone-based surfactant include Paintad M (manufactured by Dow Corning Toray Co., Ltd.), Topica K1000, Topica K2000, and Topica K5000 (all manufactured by Takachiho Industry Co., Ltd.), XL-121(polyether modified silicone-based surfactant, manufactured by Clariant Co.), BYK-310 (polyester modified silicone-based surfactant, manufactured by BYK), and the like.

Additionally, in order to finely adjust the solubility in a developing solution, the chemically amplified positive-type photosensitive composition may further contain an acid, an acid anhydride, or a solvent having a high boiling point.

Specific examples of the acid and acid anhydride include monocarboxylic acids such as acetic acid, propionic acid, n-butyric acid, isobutyric acid, n-valeric acid, isovaleric acid, benzoic acid, and cinnamic acid; hydroxymonocarboxylic acids such as lactic acid, 2-hydroxybutyric acid, 3-hydroxybutyric acid, salicylic acid, m-hydroxybenzoic acid, p-hydroxybenzoic acid, 2-hydroxycinnamic acid, 3-hydroxycinnamic acid, 4-hydroxycinnamic acid, 5-hydroxyisophthalic acid, and syringic acid; polyvalent carboxylic acids such as oxalic acid, succinic acid, glutaric acid, adipic acid, maleic acid, itaconic acid, hexahydrophthalic acid, phthalic acid, isophthalic acid, terephthalic acid, 1,2-cyclohexanedicarboxylic acid, 1,2,4-cyclohexanetricarboxylic acid, butanetetracarboxylic acid, trimellitic acid, pyromellitic acid, cyclopentanetetracarboxylic acid, butanetetracarboxylic acid, and 1,2,5,8-naphthalenetetracarboxylic acid; acid anhydrides such as itaconic anhydride, succinic anhydride, citraconic anhydride, dodecenylsuccinic anhydride, tricarbanilic anhydride, maleic anhydride, hexahydrophthalic anhydride, methyltetrahydrophthalic anhydride, Himic anhydride, 1,2,3,4-butanetetracarboxylic anhydride, cyclopentanetetracarboxylic dianhydride, phthalic anhydride, pyromellitic anhydride, trimellitic anhydride, benzophenonetetracarboxylic anhydride, ethylene glycol bis anhydrous trimellitate, and glycerin tris anhydrous trimellitate; and the like.

Furthermore, specific examples of the solvent having a high boiling point include N-methylformamide, N,N-dimethylformamide, N-methylformanilide, N-methylacetamide, N,N-dimethlyacetamide, N-methylpyrrolidone, dimethyl sulfoxide, benzyl ethyl ether, dihexyl ether, acetonyl acetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl cellosolve acetate, and the like.

Moreover, the chemically amplified positive-type photosensitive composition may further contain a sensitizer for improving the sensitivity.

### [Method of preparing chemically amplified positive-type photosensitive composition]

A chemically amplified positive-type photosensitive composition is prepared by mixing and stirring the constituting component of the composition by the common method. Machines which can be used for mixing and stirring the above components include dissolvers, homogenizers, 3-roll mills and the like. After uniformly mixing the above components, the resulting mixture may be filtered through a mesh, a membrane filter and the like.

### [Method of providing photosensitive composition]

A method of providing a photosensitive composition of the present embodiment provides the photosensitive composition to a process line carrying out the method of manufacturing a plated article mentioned above. The photosensitive composition herein may be those prepared from the above-mentioned materials appropriately selected and may be prepared with the timing depending on a size or an operating speed of the process line. Furthermore, an implementing body carrying out the method of manufacturing a plated article does not need to be necessarily the same as an implementing body carrying out the present method of providing.

### EXAMPLES

The present invention will now be described in more detail by way of Examples, but the present invention is not limited to these Examples.

### [Examples 1 to 45 and Comparative Examples 1 to 48]

In Examples 1 to 45 and Comparative Examples 1 to 48 described below, a chemically amplified positive-type photosensitive composition including an acid generator (A) which generated acid upon exposure to an irradiated actinic ray or radiation, a resin (B) whose solubility in alkali increased under an action of an acid, a sulfur-containing compound and/or a nitrogen-containing compound (C) each having a predetermined structure, and an alkali soluble resin (D), an acid diffusion suppressing agent (E), and an organic solvent (S) was used as the photosensitive composition.

In Examples 1 to 45 and Comparative Examples 1 to 48, Compounds A1 and A2 having formulas below were used as the acid generator (A).

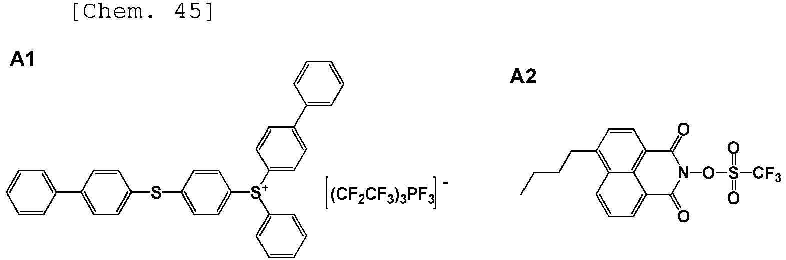

In Examples 1 to 45 and Comparative Examples 1 to 48, the following Resins B1, B2, and B3 were used as the resin whose solubility in alkali increased under an action of the acid (resin (B)). The number at the lower right of the parentheses in each constituent unit in the following structural formula represents the content (% by mass) of the constituent unit in each resin. Resin B1 has a mass average molecular weight Mw of 40,000, and dispersivity (Mw/Mn) of 2.6. Resin B2 has a mass average molecular weight Mw of 40,000, and dispersivity (Mw/Mn) of 2.6. Resin B3 has a number average molecular weight of 103,000.

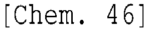

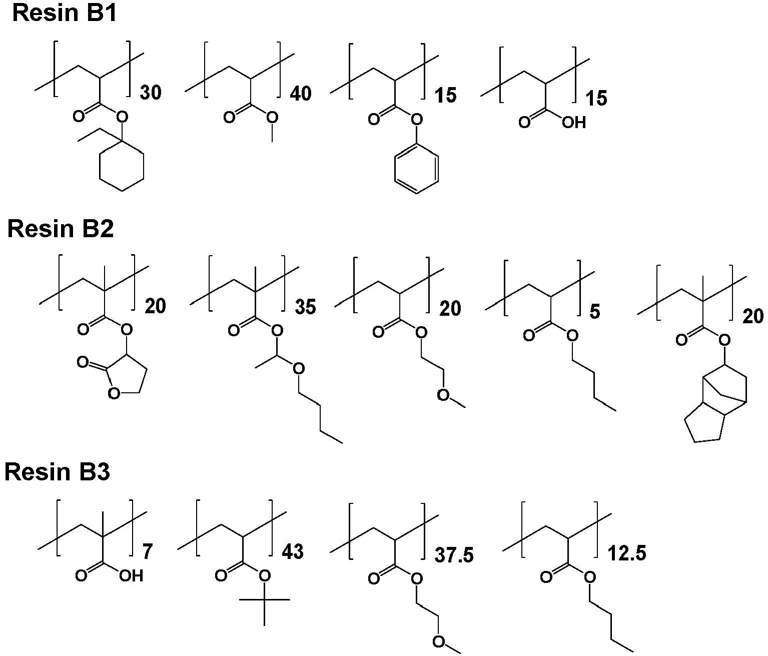

In Examples 1 to 45, Comparative Examples 1 to 15, Comparative Examples 17 to 31, and Comparative Examples 33 to 47, the following C1 to C12 were used as the sulfur-containing compound and/or the nitrogen-containing compound (C). In Comparative Examples 16, 32, and 48, the sulfur-containing compound and/or the nitrogen-containing compound (C) was not used.

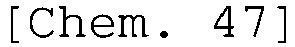

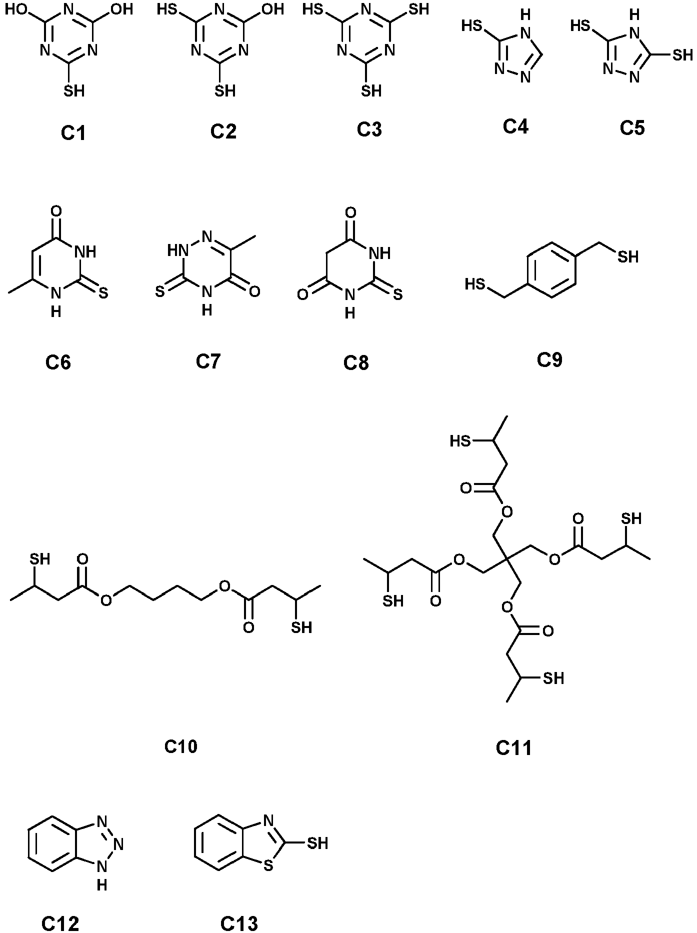

The following Resins D1 and D2 were used as the alkali soluble resin (D).
D1: polyhydroxystyrene resin (copolymer of p-hydroxystyrene : styrene = 85 : 15 (mass ratio), mass average molecular weight (Mw): 2500, dispersivity (Mw/Mn): 2.4)
D2: novolac resin (m-cresol single condensate (mass average molecular weight (Mw): 8000))

In Examples 1 to 45 and Comparative Examples 1 to 48, Tripentylamine E1 and LA63-P E2 (manufactured by ADEKA) were used as the acid diffusion suppressing agent (E).

The resin (B), the mercapto compound (C), and the alkali soluble resin (D) in types and amounts shown in Tables 1 to 4; the acid generator (A) in types and amounts shown in Tables 1 to 5; 0.2 parts by mass of the acid diffusion suppressing agent (E) in types shown in Tables 1 to 4; and 0.05 parts by mass of a surfactant (BYK310, manufactured by BYK) were dissolved in a mixed solvent of 3-methoxybutyl acetate (MA) and propylene glycol monomethyl ether acetate (PM) (MA/PM = 6/4 (mass ratio)) so to have the solid content concentration of 40% by mass to obtain the photosensitive compositions of Examples and Comparative Examples. Using the obtained photosensitive compositions, resist patterns to be used for those other than plated articles and plated articles were formed and evaluated as follows. Evaluation results are presented in Tables 1 to 5.

### [Footing (shape) evaluation: Examples 1 to 30 and Comparative Examples 1 to 32]

The photosensitive compositions of Examples and Comparative Examples were each applied onto a copper substrate having a diameter of 8 inches to form a photosensitive composition film having a film thickness of 55 µm. Then, the photosensitive composition film was pre-baked at 100°C for 5 minutes. After the pre-baking, using a mask having a square pattern capable of forming a rectangular opening of 30 µm by 30 µm and an exposure device PRISMA GHI (manufactured by Ultratech Inc.), pattern exposure was performed with a ghi line at an exposure dose greater by 1.2 times than the minimum exposure dose capable of forming a pattern having a predetermined size. Subsequently, the substrate was mounted on a hot plate and post-exposure baking (PEB) was performed at 100°C for 3 minutes. Thereafter, an aqueous 2.38% by weight solution of tetramethylammonium hydroxide (developing solution, NMD-3, manufactured by Tokyo Ohka Kogyo Co., Ltd.) was added dropwise to the exposed photosensitive composition film, and then allowed to stand at 23°C for 60 seconds. This operation was repeated four times in total. Subsequently, the surface of the resist pattern was washed with running water, and then blown with nitrogen to obtain a resist pattern. The cross-sectional shape of this resist pattern was observed under a scanning electron microscope to measure a footing amount of each of Examples 1 to 30 and Comparative Examples 1 to 32. Specifically, the footing amount was measured as follows. A schematic diagram illustrating a cross-section of a resist portion and a nonresist portion when the footing amount is measured is illustrated in FIG. 1. In FIG. 1, a resist pattern having a resist portion 12 and a nonresist portion 13 (hole) is formed on a substrate 11. Firstly, on a side wall 14 which is an interface between the resist portion 12 and the nonresist portion 13, a flexion point 15 at which footing starts on the side wall 14 was determined. A perpendicular line 16 is drawn down from the flexion point 15 to a surface of the substrate 11, and an intersection of the perpendicular line 16 with the surface of the substrate 11 was determined as a footing starting point 17. Furthermore, an intersection of a curve on the side wall 14 with the surface of the substrate 11 was determined as a footing end point 18. A width Wf between the thus-determined footing starting point 17 and footing end point 18 was determined as the footing amount. The footing amount is a value measured for any one of side walls 14 in any one nonresist portions in the resist pattern. From the value of the thus-determined footing amount, a degree of the footing was evaluated according to the following criteria:

### <Evaluation criteria of footing>

Good: 0 µm or more and 1.5 µm or less
Fair: more than 1.5 µm and 2.5 µm or less
Poor: more than 2.5 µm

### [Evaluation of adhesiveness of plated article: Examples 1 to 30]

Resist patterns were formed on three substrates in the same manner as in the footing evaluation. After forming the resist patterns, for one of the three substrates, a surface made of copper which was exposed on the nonresist portion in the resist pattern was subjected to plasma ashing using an oxygen gas (O₂). Furthermore, for one of the three substrates, the surface made of copper which was exposed on the nonresist portion in the resist pattern was subjected to plasma ashing using a mixed gas (O₂/CF₄ = 9/1 (volume ratio)). Additionally, for one of the three substrates, the surface made of copper which was exposed on the nonresist portion in the resist pattern was subjected to plasma ashing using a mixed gas (O₂/CF₄ = 7/3 (volume ratio)). Note here that the plasma ashing was carried out under the following conditions: treatment time of 60 seconds, treatment temperature of 25°C, and plasma generator output of 300 W. Each of the three substrates subjected to the plasma ashing using different gases was plated using a copper sulfate plating solution under the conditions of a liquid temperature of 25°C and a cathodic current density of 5 ASD (A/dm²) until a plating height reached 50 µm to form a cuboidal plated article on the surface made of copper of the substrate. After forming the plated article, the plated article was rinsed with acetone to detach the resist pattern used as the template for forming the plated article. The surface of the substrate from which the resist pattern had been detached was observed under an electron microscope to confirm the presence or absence of displacement and inclination in the plated article and evaluate adhesiveness of the plated article. When the displacement or the inclination was not observed, it was evaluated as Good, and when the displacement or the inclination was observed, it was evaluated as Poor.

### [Evaluation of adhesiveness of plated article: Comparative Examples 1 to 32]

Plating and detachment of the resist pattern were carried out in the same manner as in the evaluation of Examples 1 to 30, except that the plasma ashing was not carried out, and adhesiveness of the plated article was evaluated.

### [Footing (shape) evaluation: Examples 31 to 45 and Comparative Examples 33 to 48]

The photosensitive compositions of Examples and Comparative Examples were each applied onto a copper substrate having a diameter of 8 inches to form a photosensitive composition film having a film thickness of 7 µm. Then, the photosensitive composition film was pre-baked at 130°C for 5 minutes. After the pre-baking, using a mask having a line-and-space pattern having a line width of 2.0 µm and a space width of 2.0 µm and an exposure device PRISMA GHI (manufactured by Ultratech Inc.), pattern exposure was performed with a ghi line at an exposure dose greater by 1.2 times than the minimum exposure dose capable of forming a pattern having a predetermined size. Subsequently, the substrate was placed on a hot plate and post-exposure baking (PEB) was performed at 90°C for 1.5 minutes. Thereafter, an aqueous 2.38% by weight solution of tetramethylammonium hydroxide (developing solution, NMD-3, manufactured by Tokyo Ohka Kogyo Co., Ltd.) was added dropwise to the exposed photosensitive composition film, and then allowed to stand at 23°C for 30 seconds. This operation was repeated twice in total. Subsequently, the surface of the resist pattern was washed with running water, and then blown with nitrogen to obtain a resist pattern. The cross-sectional shape of this resist pattern was observed under a scanning electron microscope to measure the footing amount in the same manner as in Example 1. From the value of the footing amount, a degree of the footing was evaluated according to the following criteria:

### <Evaluation criteria of footing>

Good: 0 µm or more and 0.5 µm or less
Fair: more than 0.5 µm and 1.0 µm or less
Poor: more than 1.0 µm

### [Evaluation of adhesiveness of plated article: Examples 31 to 45 and Comparative Examples 33 to 48]

Plating and detachment of the resist pattern were carried out in the same manner as in the evaluation of Examples 1 or Comparative Example 1, except that the plating height was changed to 5 µm, and adhesiveness of the plated article was evaluated.

**[Table 1]**

| | Resin (B) | Alkali soluble resin (D) | Mercapto compound (C) | Acid generator (A) | Acid diffusion suppressing agent (E) | Shape | Adhesiveness of plated article | | |
|---|---|---|---|---|---|---|---|---|---|
| | | | | | | | O₂ | O₂/CF₄ = 9/1 | O₂/CF₄ = 7/3 |
| | Type/ Parts by mass | Type/ Parts by mass | Type/ Parts by mass | Type/ Parts by mass | Type | | | | |
| Ex. 1 | | | C1/0.05 | | | Good | Good | Good | Good |
| Ex. 2 | | | C2/0.05 | | | Good | Good | Good | Good |
| Ex. 3 | | | C3/0.05 | | | Good | Good | Good | Good |
| Ex. 4 | | | C4/0.05 | | | Good | Good | Good | Good |
| Ex. 5 | | | C5/0.05 | | | Good | Good | Good | Good |
| Ex. 6 | | | C6/0.05 | | | Fair | Good | Good | Good |
| Ex. 7 | | Dl/20 D2/40 | C7/0.05 | | | Fair | Good | Good | Good |
| Ex. 8 | Bl/40 | | C8/0.05 | A1/4 | E1 | Fair | Good | Good | Good |
| Ex. 9 | | | C9/0.05 | | | Good | Good | Good | Good |
| Ex. 10 | | | C10/0.05 | | | Good | Good | Good | Good |
| Ex. 11 | | | C11/0.05 | | | Good | Good | Good | Good |
| Ex. 12 | | | C12/0.05 | | | Fair | Good | Good | Good |
| Ex. 13 | | | C13/0.05 | | | Fair | Good | Good | Good |
| Ex. 14 | | | C2/0.15 | | | Good | Good | Good | Good |
| Ex. 15 | | | C10/0.15 | | | Good | Good | Good | Good |
| Ex. 16 | | | C1/0.05 | | | Good | Good | Good | Good |
| Ex. 17 | | | C2/0.05 | | | Good | Good | Good | Good |
| Ex. 18 | | | C3/0.05 | | | Good | Good | Good | Good |
| Ex. 19 | | | C4/0.05 | | | Good | Good | Good | Good |
| Ex. 20 | | | C5/0.05 | | | Good | Good | Good | Good |
| Ex. 21 | | | C6/0.05 | | | Fair | Good | Good | Good |
| Ex. 22 | B2/ 100 | | C7/0.05 | | | Fair | Good | Good | Good |
| Ex. 23 | | - | C8/0.05 | A1/4 | E1 | Fair | Good | Good | Good |
| Ex. 24 | | | C9/0.05 | | | Good | Good | Good | Good |
| Ex. 25 | | | C10/0.05 | | | Good | Good | Good | Good |
| Ex. 26 | | | C11/0.05 | | | Good | Good | Good | Good |
| Ex. 27 | | | C12/0.05 | | | Fair | Good | Good | Good |
| Ex. 28 | | | C13/0.05 | | | Fair | Good | Good | Good |
| Ex. 29 | | | C2/0.15 | | | Good | Good | Good | Good |
| Ex. 30 | | | C10/0.15 | | | Good | Good | Good | Good |

**[Table 2]**

| | Resin (B) | Alkali soluble resin (D) | Mercapto compound (C) | Acid generator (A) | Acid diffusion suppressing agent (E) | Shape | Adhesiveness of plated article (No ashing) |
|---|---|---|---|---|---|---|---|
| | Type/ Parts by mass | Type/ Parts by mass | Type/ Parts by mass | Type/ Parts by mass | Type | | |
| Comp. Ex. 1 | | | C1/0.05 | | | Good | Poor |
| Comp. Ex. 2 | | | C2/0.05 | | | Good | Poor |
| Comp. Ex. 3 | | | C3/0.05 | | | Good | Poor |
| Comp. Ex. 4 | | | C4/0.05 | | | Good | Poor |
| Comp. Ex. 5 | | | C5/0.05 | | | Good | Poor |
| Comp. Ex. 6 | | | C6/0.05 | | | Fair | Poor |
| Comp. Ex. 7 | | | C7/0.05 | | | Fair | Poor |
| Comp. Ex. 8 | Bl/40 | Dl/20 D2/40 | C8/0.05 | A1/4 | E1 | Fair | Poor |
| Comp. Ex. 9 | | | C9/0.05 | | | Good | Poor |
| Comp. Ex. 10 | | | C10/0.05 | | | Good | Poor |
| Comp. Ex. 11 | | | C11/0.05 | | | Good | Poor |
| Comp. Ex. 12 | | | C12/0.05 | | | Fair | Poor |
| Comp. Ex. 13 | | | C13/0.05 | | | Fair | Poor |
| Comp. Ex. 14 | | | C2/0.15 | | | Good | Poor |
| Comp. Ex. 15 | | | C10/0.15 | | | Good | Poor |
| Comp. Ex. 16 | | | - | | | Poor | Good |
| Comp. Ex. 17 | | | C1/0.05 | | | Good | Poor |
| Comp. Ex. 18 | | | C2/0.05 | | | Good | Poor |
| Comp. Ex. 19 | | | C3/0.05 | | | Good | Poor |
| Comp. Ex. 20 | | | C4/0.05 | | | Good | Poor |
| Comp. Ex. 21 | | | C5/0.05 | | | Good | Poor |
| Comp. Ex. 22 | | | C6/0.05 | | | Fair | Poor |
| Comp. Ex. 23 | | | C7/0.05 | | | Fair | Poor |
| Comp. Ex. 24 | B2/ 100 | - | C8/0.05 | A1/4 | E1 | Fair | Poor |
| Comp. Ex. 25 | | | C9/0.05 | | | Good | Poor |
| Comp. Ex. 26 | | | C10/0.05 | | | Good | Poor |
| Comp. Ex. 27 | | | C11/0.05 | | | Good | Poor |
| Comp. Ex. 28 | | | C12/0.05 | | | Fair | Poor |
| Comp. Ex. 29 | | | C13/0.05 | | | Fair | Poor |
| Comp. Ex. 30 | | | C2/0.15 | | | Good | Poor |
| Comp. Ex. 31 | | | C10/0.15 | | | Good | Poor |
| Comp. Ex. 32 | | | - | | | Poor | Good |

**[Table 3]**

| | Resin (B) | Alkali soluble resin (D) | Mercapto compound (C) | Acid generator (A) | Acid diffusion suppressing agent (E) | 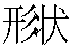 | Adhesiveness of plated article | | |
|---|---|---|---|---|---|---|---|---|---|
| | | | | | | | O₂ | O₂/CF₄ = 9/1 | O₂/CF₄ = 7/3 |
| | Type/ Parts by mass | Type/ Parts by mass | Type/ Parts by mass | Type/ Parts by mass | Type | | | | |
| Ex. 31 | B3/35 | Dl/10 D2/55 | C1/0.05 | A2/1 | E2 | Good | Good | Good | Good |
| Ex. 32 | | | C2/0.05 | | | Good | Good | Good | Good |
| Ex. 33 | | | C3/0.05 | | | Good | Good | Good | Good |
| Ex. 34 | | | C4/0.05 | | | Good | Good | Good | Good |
| Ex. 35 | | | C5/0.05 | | | Good | Good | Good | Good |
| Ex. 36 | | | C6/0.05 | | | Fair | Good | Good | Good |
| Ex. 37 | | | C7/0.05 | | | Fair | Good | Good | Good |
| Ex. 38 | | | C8/0.05 | | | Fair | Good | Good | Good |
| Ex. 39 | | | C9/0.05 | | | Good | Good | Good | Good |
| Ex. 40 | | | C10/0.05 | | | Good | Good | Good | Good |
| Ex. 41 | | | C11/0.05 | | | Good | Good | Good | Good |
| Ex. 42 | | | C12/0.05 | | | Fair | Good | Good | Good |
| Ex. 43 | | | C13/0.05 | | | Fair | Good | Good | Good |
| Ex. 44 | | | C2/0.15 | | | Good | Good | Good | Good |
| Ex. 45 | | | C10/0.15 | | | Good | Good | Good | Good |

**[Table 4]**

| | Resin (B) | Alkali soluble resin (D) | Mercapto compound (C) | Acid generator (A) | Acid diffusion suppressing agent (E) | Shape | Adhesiveness of plated article (No ashing) |
|---|---|---|---|---|---|---|---|
| | Type/ Parts by mass | Type/ Parts by mass | Type/ Parts by mass | Type/ Parts by mass | Type | | |
| Comp. Ex. 33 | | | C1/0.05 | | | Good | Poor |
| Comp. Ex. 34 | | | C2/0.05 | | | Good | Poor |
| Comp. Ex. 35 | | | C3/0.05 | | | Good | Poor |
| Comp. Ex. 36 | | | C4/0.05 | | | Good | Poor |
| Comp. Ex. 37 | | | C5/0.05 | | | Good | Poor |
| Comp. Ex. 38 | | | C6/0.05 | | | Fair | Poor |
| Comp. Ex. 39 | | | C7/0.05 | | | Fair | Poor |
| Comp. Ex. 40 | B3/35 | Dl/10 D2/55 | C8/0.05 | A2/1 | E2 | Fair | Poor |
| Comp. Ex. 41 | | | C9/0.05 | | | Good | Poor |
| Comp. Ex. 42 | | | C10/0.05 | | | Good | Poor |
| Comp. Ex. 43 | | | C11/0.05 | | | Good | Poor |
| Comp. Ex. 44 | | | C12/0.05 | | | Fair | Poor |
| Comp. Ex. 45 | | | C13/0.05 | | | Fair | Poor |
| Comp. Ex. 46 | | | C2/0.15 | | | Good | Poor |
| Comp. Ex. 47 | | | C10/0.15 | | | Good | Poor |
| Comp. Ex. 48 | | | - | | | Poor | Good |

According to Examples 1 to 45, it can be seen that a plated article having favorable adhesiveness with respect to a surface made of metal on a substrate while suppressing footing in a resist pattern to be used as a template can be formed by forming the resist pattern to be used as the template for forming the plated article using a photosensitive composition which includes a sulfur-containing compound and/or a nitrogen-containing compound (C) each having a predetermined structure and, before the plated article is formed therefrom, subjecting a surface made of metal exposed from a nonresist portion of the resist pattern to be used as the template to ashing.

On the other hand, according to Comparative Examples 1 to 15, Comparative Examples 17 to 31, and Comparative Examples 33 to 47, it can be seen that, when a resist pattern to be used as a template for forming a plated article is formed using a photosensitive composition which includes a sulfur-containing compound and/or a nitrogen-containing compound (C) each having a predetermined structure, adhesiveness of the plated article formed therefrom with respect to a surface made of metal on a substrate is damaged unless the surface made of metal exposed from a nonresist portion in the resist pattern to be used as the template is subjected to ashing before the plated article is formed.

Furthermore, it can be seen from Comparative Example 16, Comparative Example 32, and Comparative Example 48 that, when a resist pattern to be used as a template for forming a plated article is formed using a photosensitive composition which does not include a sulfur-containing compound and/or a nitrogen-containing compound (C) each having a predetermined structure, footing tends to occur on the formed resist pattern.

## Claims

1. A method of manufacturing a plated article, the method comprising: preparing a substrate having a metal layer on a surface thereof and a photosensitive composition;
applying the photosensitive composition onto the substrate to form a photosensitive composition film;
exposing the photosensitive composition film;
developing the exposed photosensitive composition film to form a pattern so that at least a portion of the metal layer on the substrate is exposed; and
forming a plated article using the pattern as a template,
the photosensitive composition comprises a sulfur-containing compound and/or a nitrogen-containing compound,
wherein the sulfur-containing compound comprises a sulfur atom to be coordinated with metal constituting the metal layer,
the nitrogen-containing compound comprises a nitrogen atom constituting a nitrogen-containing aromatic heterocycle to be coordinated with metal constituting the metal layer, and
the method further comprises subjecting the exposed surface of the metal layer to an ashing treatment between forming the pattern and forming the plated article.

2. The method of manufacturing a plated article according to claim 1, wherein the photosensitive composition comprises a mercapto group-containing compound as the sulfur-containing compound.

3. The method of manufacturing a plated article according to claim 1 or 2, wherein the photosensitive composition is a positive-type photosensitive composition.

4. The method of manufacturing a plated article according to claim 3, wherein the photosensitive composition is a chemically amplified positive-type photosensitive composition.

5. The method of manufacturing a plated article according to any one of claims 1 to 4, wherein the ashing treatment is carried out using an oxygen plasma.

6. A method of providing a photosensitive composition, comprising providing the photosensitive composition to a process line carrying out the method of manufacturing a plated article according to any one of claims 1 to 5.

7. The method of providing a photosensitive composition according to claim 6, wherein the photosensitive composition comprises a mercapto group-containing compound as the sulfur-containing compound.
